# EUROPEAN PATENT APPLICATION

(11) **EP 4 261 870 A1**
(43) Date of publication of application: **18.10.2023**
(21) Application number: 21906289.0
(22) Date of filing: 25.11.2021
(51) Int. Cl.: H01L 21/205, C23C 16/455

(54) **VAPOR-PHASE GROWTH APPARATUS AND VAPOR-PHASE GROWTH METHOD**

(30) Priority: 14.12.2020 JP 2020206807
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); ISHIGURO, Akio, Yokohama-shi, Kanagawa 235-8522 (JP); KURASHIMA, Keisuke, Yokohama-shi, Kanagawa 235-8522 (JP); ISHII, Shigeaki, Yokohama-shi, Kanagawa 235-8522 (JP)
(74) Representative: Hoffmann Eitle
(86) International application number: PCT/JP2021/043169
(87) International publication number: WO 2022/130926

(57) **Abstract**

A vapor phase growth apparatus according to an embodiment includes: a reactor; a holder provided in the reactor, a substrate being placed on the holder; a first source gas flow path configured to supply a first source gas containing silicon and chlorine into the reactor; and a purge gas flow path configured to supply a purge gas containing silicon and chlorine into the reactor, the atomic concentration of silicon in the purge gas being lower than that in the first source gas.

## Description

### TECHNICAL FIELD

The present invention relates to a vapor phase growth apparatus and a vapor phase growth method for forming a film by supplying a gas to a substrate.

### BACKGROUND ART

As a method of forming a high-quality semiconductor film, there is an epitaxial growth technique for forming a single crystal film on the surface of a substrate by vapor phase growth. In a vapor phase growth apparatus using the epitaxial growth technique, a substrate is placed on a holder in a reactor held at atmospheric pressure or reduced pressure.

Then, while heating the substrate, a process gas containing the raw material of a film is supplied to the reactor through a gas introduction unit above the reactor. A thermal reaction of the process gas occurs on the surface of the substrate, and an epitaxial single crystal film is formed on the surface of the substrate.

In such a vapor phase growth apparatus, the reproducibility of the characteristics of a film formed under the same process conditions may not be obtained. As a cause of this, for example, a change with time in the concentration of the raw material of the film in the process gas supplied onto the wafer can be mentioned.

### CITATION LIST

### PATENT DOCUMENT

Patent Document 1: JP 2016-162921 A

### SUMMARY OF THE INVENTION

### PROBLEM TO BE SOLVED BY THE INVENTION

A problem to be solved by the invention is to provide a vapor phase growth apparatus capable of improving the reproducibility of film characteristics.

### MEANS FOR SOLVING PROBLEM

A vapor phase growth apparatus according to one aspect of the invention includes: a reactor; a holder provided in the reactor, a substrate being placed on the holder; a first source gas flow path configured to supply a first source gas containing silicon and chlorine into the reactor; and a purge gas flow path configured to supply a purge gas containing silicon and chlorine into the reactor, an atomic concentration of silicon in the purge gas being lower than that in the first source gas.

A vapor phase growth apparatus according to one aspect of the invention includes: a reactor; a holder provided in the reactor, a substrate being placed on the holder; and a gas introduction unit provided above the reactor. The gas introduction unit includes: a source gas region, a source gas containing silicon and chlorine being introduced into the source gas region; a purge gas region provided between the source gas region and the reactor, a purge gas containing chlorine being introduced into the purge gas region; a first partition plate provided between the source gas region and the purge gas region; a second partition plate provided between the purge gas region and the reactor; a source gas conduit passing through the first partition plate and the second partition plate and supplying the source gas to the reactor; and a purge gas conduit passing through the second partition plate and supplying the purge gas containing silicon with an atomic concentration lower than an atomic concentration of silicon in the source gas to the reactor through a gap between the source gas conduit and the purge gas conduit, the source gas conduit being inserted into the purge gas conduit. The gas introduction unit has a gap between the source gas conduit and the first partition plate.

A vapor phase growth method according to one aspect of the invention is a vapor phase growth method using a vapor phase growth apparatus including a reactor, a holder provided in the reactor to place a substrate thereon, a source gas flow path configured to supply a source gas into the reactor, and a purge gas flow path configured to supply a purge gas into the reactor. The vapor phase growth method includes: supplying the source gas containing silicon and chlorine to the reactor through the source gas flow path; supplying a purge gas containing silicon and chlorine to the reactor through the purge gas flow path, an atomic concentration of silicon in the purge gas being lower than that in the source gas; and forming a silicon carbide film on a surface of the substrate.

### EFFECT OF THE INVENTION

According to the invention, it is possible to realize a vapor phase growth apparatus capable of improving the reproducibility of film characteristics.

### BRIEF DESCRIPTION OF DRAWINGS

Fig. 1 is a schematic cross-sectional view of a vapor phase growth apparatus according to a first embodiment;
Fig. 2 is an enlarged schematic cross-sectional view of a part of a gas chamber of the vapor phase growth apparatus according to the first embodiment;
Fig. 3 is an enlarged schematic cross-sectional view of a part of a gas chamber of the vapor phase growth apparatus according to the first embodiment;
Fig. 4 is an enlarged schematic cross-sectional view of a part of a gas chamber of the vapor phase growth apparatus according to the first embodiment;
Fig. 5 is an explanatory diagram of a vapor phase growth method according to the first embodiment;
Fig. 6 is an explanatory diagram of the vapor phase growth method according to the first embodiment;
Fig. 7 is an explanatory diagram of the vapor phase growth method according to the first embodiment;
Fig. 8 is an explanatory diagram of the function and effect of the vapor phase growth apparatus according to the first embodiment;
Fig. 9 is an explanatory diagram of the function and effect of the vapor phase growth apparatus according to the first embodiment;
Fig. 10 is an enlarged schematic cross-sectional view of a part of a gas chamber in a modification example of the vapor phase growth apparatus according to the first embodiment;
Fig. 11 is an explanatory diagram of a modification example of the vapor phase growth method according to the first embodiment;
Fig. 12 is an explanatory diagram of the function and effect of the modification example of the vapor phase growth apparatus according to the first embodiment;
Fig. 13 is a schematic cross-sectional view of a vapor phase growth apparatus according to a second embodiment;
Fig. 14 is an enlarged schematic cross-sectional view of a part of a gas chamber of the vapor phase growth apparatus according to the second embodiment;
Fig. 15 is an explanatory diagram of a vapor phase growth method according to the second embodiment;
Fig. 16 is an explanatory diagram of the function and effect of the vapor phase growth apparatus according to the second embodiment;
Fig. 17 is a schematic cross-sectional view of a vapor phase growth apparatus according to a third embodiment;
Fig. 18 is an enlarged schematic cross-sectional view of a part of a gas chamber of a vapor phase growth apparatus according to a fourth embodiment;
Fig. 19 is an explanatory diagram of a vapor phase growth method according to the fourth embodiment;
Fig. 20 is an enlarged schematic cross-sectional view of a part of a gas chamber of the vapor phase growth apparatus according to the fourth embodiment; and
Fig. 21 is an explanatory diagram of the function and effect of the vapor phase growth apparatus according to the fourth embodiment.

### EMBODIMENT(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film, and is a concept including, for example, a source gas, an assist gas, a dopant gas, a carrier gas, a purge gas, and a mixed gas thereof.

### (First Embodiment)

A vapor phase growth apparatus according to a first embodiment includes: a reactor; a holder provided in the reactor, a substrate being placed on the holder; a first source gas flow path configured to supply a first source gas containing silicon and chlorine into the reactor; and a purge gas flow path configured to supply a purge gas containing silicon and chlorine into the reactor, an atomic concentration of silicon in the purge gas being lower than that in the first source gas.

In addition, a vapor phase growth apparatus according to the first embodiment includes: a reactor; a holder provided in the reactor, a substrate being placed on the holder; and a gas introduction unit provided above the reactor. The gas introduction unit includes: a source gas region, a source gas containing silicon and chlorine being introduced into the source gas region; a purge gas region provided between the source gas region and the reactor, a purge gas containing chlorine being introduced into the purge gas region; a first partition plate provided between the source gas region and the purge gas region; a second partition plate provided between the purge gas region and the reactor; a source gas conduit passing through the first partition plate and the second partition plate and supplying the source gas to the reactor; and a purge gas conduit passing through the second partition plate and supplying the purge gas containing silicon with an atomic concentration lower than an atomic concentration of silicon in the source gas to the reactor through a gap between the source gas conduit and the purge gas conduit, the source gas conduit being inserted into the purge gas conduit. The gas introduction unit has a gap between the source gas conduit and the first partition plate.

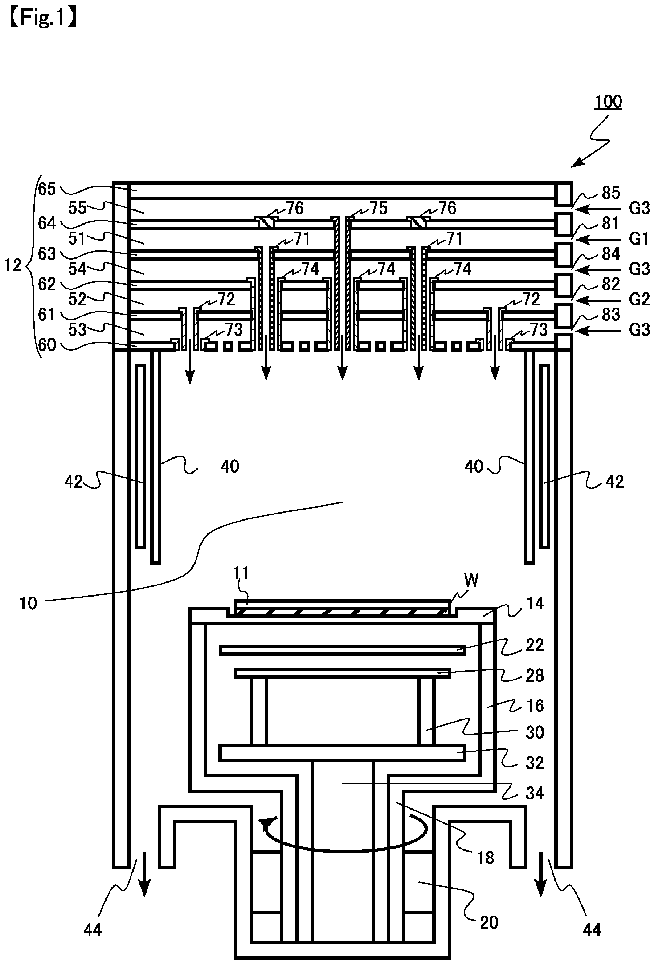

Fig. 1 is a schematic cross-sectional view of the vapor phase growth apparatus according to the first embodiment. A vapor phase growth apparatus 100 according to the first embodiment is, for example, a single wafer type epitaxial growth apparatus that epitaxially grows a single crystal SiC film on a single crystal SiC substrate. The vapor phase growth apparatus 100 according to the first embodiment is a vertical vapor phase growth apparatus in which a process gas is supplied in a vertical direction to the surface of the SiC substrate.

The vapor phase growth apparatus 100 according to the first embodiment includes a reactor 10 and a gas introduction unit 12. The reactor 10 includes a susceptor 14 (holder), a rotating body 16, a rotating shaft 18, a rotation driving mechanism 20, a first heater 22, a reflector 28, a support column 30, a fixing table 32, a fixing shaft 34, a hood 40, a second heater 42, and a gas discharge port 44. The gas introduction unit 12 includes source gas regions 51 and 52, purge gas regions 53, 54, and 55, a rectifying plate 60, partition plates 61, 62, 63, and 64, a top plate 65, source gas conduits 71 and 72, purge gas conduits 73, 74, and 75, a gas cap 76, source gas introduction ports 81 and 82, and purge gas introduction ports 83, 84, and 85.

The susceptor 14 is an example of a holder. The partition plate 63 is an example of a first partition plate. The partition plate 62 is an example of a second partition plate.

The source gas region 51 and the source gas conduit 71 form a first source gas flow path for a source gas G1. The source gas region 52 and the source gas conduit 72 form a second source gas flow path for a source gas G2. The purge gas region 53 and the purge gas conduit 73, the purge gas region 54 and the purge gas conduit 74, and the purge gas region 55 and the purge gas conduit 75 each form a purge gas flow path for a purge gas G3.

The source gas G1 is an example of a first source gas. The source gas G2 is an example of a second source gas.

The reactor 10 is formed of, for example, stainless steel. The reactor 10 has a cylindrical wall. In the reactor 10, an SiC film is formed on a wafer W. The wafer W is an example of a substrate.

The susceptor 14 is provided in the reactor 10. The wafer W can be placed on the susceptor 14. An opening may be provided at the center of the susceptor 14. The susceptor 14 is an example of a holder.

The susceptor 14 is formed of, for example, a highly heat-resistant material such as SiC, carbon, or carbon coated with SiC or TaC.

The susceptor 14 is fixed to the upper part of the rotating body 16. The rotating body 16 is fixed to the rotating shaft 18. The susceptor 14 is indirectly fixed to the rotating shaft 18.

The rotating shaft 18 can be rotated by the rotation driving mechanism 20. By rotating the rotating shaft 18 using the rotation driving mechanism 20, it is possible to rotate the susceptor 14. By rotating the susceptor 14, it is possible to rotate the wafer W placed on the susceptor 14.

With the rotation driving mechanism 20, for example, the wafer W can be rotated at a rotation speed of 300 rpm or more and 3000 rpm or less. The rotation driving mechanism 20 is formed by, for example, a motor and a bearing.

The first heater 22 is provided below the susceptor 14. The first heater 22 is provided in the rotating body 16. The first heater 22 heats the wafer W held by the susceptor 14 from below. The first heater 22 is, for example, a resistor heater. The first heater 22 has, for example, a disc shape with a comb-shaped pattern. The first heater 22 may be divided into an outer heater for heating the outer periphery of the wafer and an inner heater for heating the inner periphery of the wafer (not shown).

The reflector 28 is provided below the first heater 22. The first heater 22 is provided between the reflector 28 and the susceptor 14.

The reflector 28 reflects the heat radiated downward from the first heater 22 to improve the heating efficiency of the wafer W. In addition, the reflector 28 prevents the members below the reflector 28 from being heated. The reflector 28 has, for example, a disk shape. The reflector 28 is formed of, for example, a highly heat-resistant material such as SiC-coated carbon.

The reflector 28 is fixed to the fixing table 32 by, for example, a plurality of support columns 30. The fixing table 32 is supported by, for example, the fixing shaft 34.

In order to attach and detach the susceptor 14 to and from the rotating body 16, a push up pin (not shown) is provided in the rotating body 16. The push up pin passes through, for example, the reflector 28 and the first heater 22.

The second heater 42 is provided between the hood 40 and the inner wall of the reactor 10. The second heater 42 heats the wafer W held by the susceptor 14 from above. By heating the wafer W with the second heater 42 in addition to the first heater 22, it is possible to heat the wafer W to a temperature required for the growth of the SiC film, for example, a temperature of 1500°C or higher. The second heater 42 is, for example, a resistor heater.

The hood 40 has, for example, a cylindrical shape. The hood 40 has a function of preventing the process gas from coming into contact with the second heater 42. The hood 40 is formed of, for example, a highly heat-resistant material such as SiC-coated carbon.

The gas discharge port 44 is provided at the bottom of the reactor 10. The gas discharge port 44 discharges a surplus reaction product after the source gas reacts on the surface of the wafer W and a surplus process gas to the outside of the reactor 10. The gas discharge port 44 is connected to, for example, a vacuum pump (not shown).

In addition, a wafer inlet/outlet and a gate valve (not shown) are provided in the reactor 10. The wafer W can be loaded into the reactor 10 or unloaded to the outside of the reactor 10 through the wafer inlet/outlet and the gate valve.

The gas introduction unit 12 is provided above the reactor 10.

In the gas introduction unit 12, the source gas introduction port 81 for introducing the source gas G1 into the gas introduction unit 12 is provided. The source gas G1 that is the first source gas is introduced into the source gas region 51 through the source gas introduction port 81.

In the gas introduction unit 12, the source gas introduction port 82 for introducing the source gas G2 into the gas introduction unit 12 is provided. The source gas G2 that is the second source gas is introduced into the source gas region 52 through the source gas introduction port 82.

In the gas introduction unit 12, the purge gas introduction ports 83, 84, and 85 for introducing the purge gas G3 into the gas introduction unit 12 are provided. The purge gas G3 is introduced into the purge gas region 53 through the purge gas introduction port 83. The purge gas G3 is introduced into the purge gas region 54 through the purge gas introduction port 84. In addition, the purge gas G3 is introduced into the purge gas region 55 through the purge gas introduction port 85.

In addition, the purge gas G3 introduced into the purge gas regions 53, 54, and 55 through the purge gas introduction ports 83, 84, and 85, respectively, is a gas that does not contain the source gas. In addition, the purge gas G3 introduced into the purge gas regions 53, 54, and 55 through the purge gas introduction ports 83, 84, and 85, respectively, is expressed by the same reference numeral in Fig. 1, but the flow rates of assist gas, carrier gas, and the like may be independently controlled.

The source gas G1 is a silicon (Si) source gas. The source gas G1 contains silicon (Si) and chlorine (Cl). The source gas G1 is, for example, a mixed gas of silane (SiH₄), hydrogen chloride (HCl), and hydrogen gas (H₂).

Hydrogen chloride (HCl) is an assist gas for suppressing the clustering of silicon. In addition, hydrogen chloride has a function of etching silicon-containing by-products deposited in the flow path for the source gas G1.

The hydrogen gas (H₂) is a carrier gas. As the carrier gas, for example, an argon gas (Ar) can also be used.

The source gas G2 is a carbon (C) source gas. The source gas G2 contains carbon (C). The source gas G2 contains, for example, hydrocarbons. The source gas G2 is, for example, a mixed gas of propane (C₃H₈) and hydrogen gas (H₂).

The source gas G2 contains, for example, a dopant gas of n-type impurities. The dopant gas of n-type impurities is, for example, a nitrogen gas.

The purge gas G3 has a function of suppressing the source gas supplied to the reactor 10 from entering the purge gas conduits 73, 74, and 75 from the reactor 10 side. That is, by supplying the purge gas G3, the occurrence of a situation is suppressed in which a source gas flows into the purge gas conduits 73, 74, and 75 from the reactor 10 side to form deposits inside the purge gas conduits 73, 74, and 75. In addition, the purge gas G3 contains chlorine (Cl). The purge gas G3 contains, for example, hydrogen chloride (HCl). The purge gas G3 is, for example, a mixed gas of hydrogen chloride (HCl) and hydrogen gas (H₂).

Hydrogen chloride (HCl) is a gas for etching silicon-containing by-products. Instead of the hydrogen gas (H₂), for example, an argon gas (Ar) can be used.

The atomic concentration of chlorine in the purge gas G3 is, for example, lower than the atomic concentration of chlorine in the first source gas. The atomic concentration of chlorine in the purge gas G3 is, for example, one-fifth or less of the atomic concentration of chlorine in the first source gas. In addition, the purge gas G3 may have different mixing ratios in the purge gas regions 53, 54, and 55, or different kinds of purge gas G3 may be used in the purge gas regions 53, 54, and 55.

The source gas G1 is introduced into the source gas region 51. The source gas region 51 is provided between the purge gas region 54 and the purge gas region 55.

The source gas G2 is introduced into the source gas region 52. The source gas region 52 is provided between the source gas region 51 and the reactor 10. In addition, the source gas region 52 is provided between the purge gas region 53 and the purge gas region 54.

The purge gas G3 is introduced into the purge gas region 53. The purge gas region 53 is provided between the purge gas region 54 and the reactor 10. In addition, the purge gas region 53 is provided between the source gas region 52 and the reactor 10.

The purge gas G3 is introduced into the purge gas region 54. The purge gas region 54 is provided between the source gas region 51 and the reactor 10. In addition, the purge gas region 54 is provided between the source gas region 51 and the source gas region 52.

The purge gas G3 is introduced into the purge gas region 55. The source gas region 51 is provided between the purge gas region 55 and the reactor 10.

The rectifying plate 60 is provided between the reactor 10 and the purge gas region 53. The rectifying plate 60 has a plurality of holes 60a and a plurality of holes 60b.

The partition plate 61 is provided between the purge gas region 53 and the source gas region 52. The partition plate 61 has a plurality of holes 61a.

The partition plate 62 is provided between the purge gas region 54 and the reactor 10. The partition plate 62 is provided between the source gas region 52 and the purge gas region 54. The partition plate 62 has a plurality of holes 62a.

The partition plate 63 is provided between the source gas region 51 and the purge gas region 54. The partition plate 63 has a hole 63a.

The partition plate 64 is provided between the purge gas region 55 and the source gas region 51. The partition plate 64 has a plurality of holes 64a.

The top plate 65 is provided above the purge gas region 55.

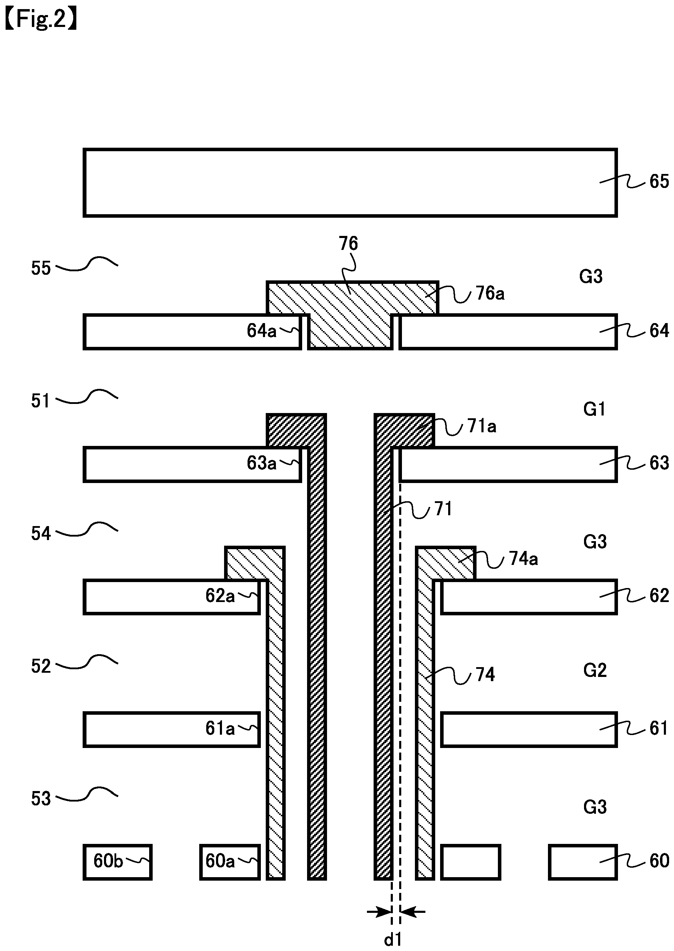

Fig. 2 is an enlarged schematic cross-sectional view of a part of a gas introduction unit of the vapor phase growth apparatus according to the first embodiment. Fig. 2 is a cross-sectional view including the source gas conduit 71 and the purge gas conduit 74.

The source gas conduit 71 supplies the source gas G1 to the reactor. The source gas conduit 71 is inserted into the holes 60a, 61a, 62a, and 63a. The source gas conduit 71 passes through the rectifying plate 60 and the partition plates 61, 62, and 63.

The source gas conduit 71 has an annular flange 71a at its upper end. The source gas conduit 71 can be removed from the partition plate 63. The source gas conduit 71 supports its own weight by placing the flange 71a on the partition plate 63.

Since the source gas conduit 71 or the partition plate 63 thermally expands due to heat input from the reactor 10 to the gas introduction unit 12, the source gas conduit 71 and the partition plate 63 are not fixed by screws or the like. If the source gas conduit 71 and the partition plate 63 are fixed by screws or the like, the source gas conduit 71 and the partition plate 63 may crack due to differences in thermal expansion or strain, which is not preferable. Therefore, on the contact surface between the flange 71a and the partition plate 63, it is not possible to obtain complete airtightness between the source gas region 51 and the purge gas region 54.

The outer wall of the source gas conduit 71 is spaced apart from the partition plate 63. There is a gap between the source gas conduit 71 and the partition plate 63. A distance (d1 in Fig. 2) between the outer wall of the source gas conduit 71 and the partition plate 63 is, for example, 100 µm or more and 1 mm or less. The distance d1 is a distance when the central axis of the source gas conduit 71 and the center of the hole 63a are aligned.

A region between the outer wall of the source gas conduit 71 and the partition plate 63 and a contact surface between the flange 71a and the partition plate 63 may function as a process gas leak path. For example, the source gas G1 may leak from the source gas region 51 to the purge gas region 54 through the contact surface between the flange 71a and the partition plate 63 and the region between the outer wall of the source gas conduit 71 and the partition plate 63. Since the source gas G1 leaks into the purge gas region 54, the source gas G1 is mixed in the purge gas region 54.

The purge gas conduit 74 supplies the purge gas G3 to the reactor 10. The purge gas conduit 74 is inserted into the holes 60a, 61a, and 62a. The purge gas conduit 74 passes through the rectifying plate 60 and the partition plates 61 and 62.

The purge gas conduit 74 has an annular flange 74a at its upper end. The purge gas conduit 74 can be removed from the partition plate 62. The purge gas conduit 74 supports its own weight by placing the flange 74a on the partition plate 62. The outer wall of the purge gas conduit 74 is spaced apart from the partition plate 62.

Since the purge gas conduit 74 or the partition plate 62 thermally expands due to heat input from the reactor 10 to the gas introduction unit 12, the purge gas conduit 74 and the partition plate 62 are not fixed by screws or the like. If the purge gas conduit 74 and the partition plate 62 are fixed by screws or the like, the purge gas conduit 74 and the partition plate 62 may crack due to differences in thermal expansion or strain, which is not preferable. Therefore, on the contact surface between the flange 74a and the partition plate 62, it is not possible to obtain complete airtightness between the source gas region 52 and the purge gas region 54.

The source gas conduit 71 is inserted inside the purge gas conduit 74. The purge gas conduit 74 and the source gas conduit 71 are spaced apart from each other. There is a gap between the purge gas conduit 74 and the source gas conduit 71. The gap between the purge gas conduit 74 and the source gas conduit 71 serves as a flow path for the purge gas G3.

The gas cap 76 is inserted into the hole 64a to close the hole 64a. The gas cap 76 suppresses the movement of the process gas between the purge gas region 55 and the source gas region 51.

The gas cap 76 has an annular flange 76a at its upper end. Since the gas cap 76 does not have a conduit to the reactor 10, the heat input from the reactor 10 to the gas introduction unit 12 is difficult to be transmitted, and accordingly, thermal expansion is also small. For this reason, the gas cap 76 may be fixed by a fixing portion (not shown) provided in the gas cap 76 so that the contact surface between the flange 76a and the partition plate 64 is airtight. The gas cap 76 can be removed.

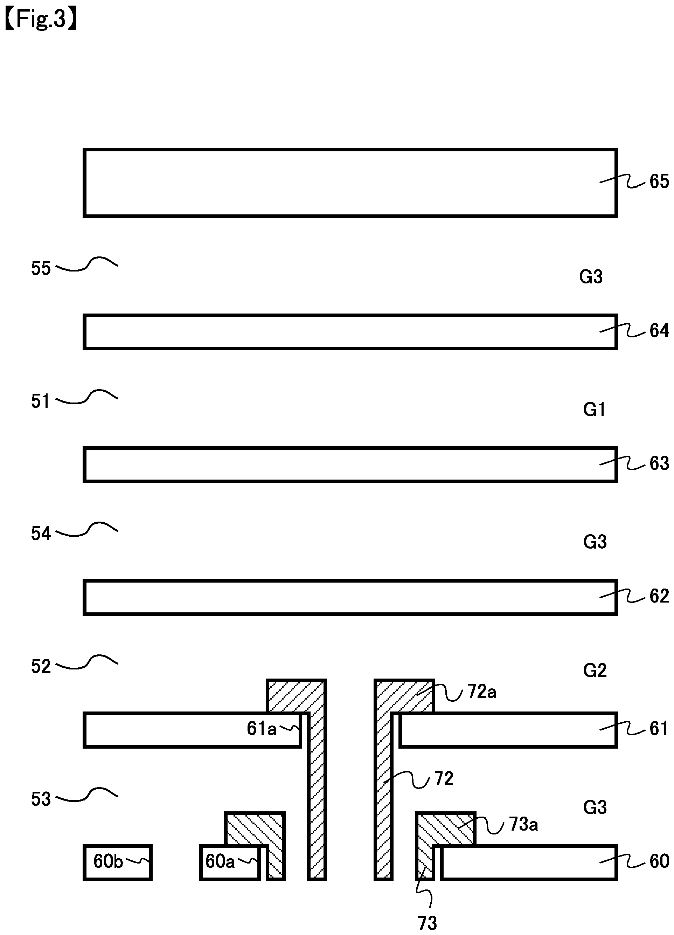

Fig. 3 is an enlarged schematic cross-sectional view of a part of a gas introduction unit of the vapor phase growth apparatus according to the first embodiment. Fig. 3 is a cross-sectional view including the source gas conduit 72 and the purge gas conduit 73.

The source gas conduit 72 supplies the source gas G2 to the reactor. The source gas conduit 72 is inserted into the holes 60a and 61a. The source gas conduit 72 passes through the rectifying plate 60 and the partition plate 61.

The source gas conduit 72 has an annular flange 72a at its upper end. The source gas conduit 72 can be removed from the partition plate 61. The source gas conduit 72 supports its own weight by placing the flange 72a on the partition plate 61. The outer wall of the source gas conduit 72 is spaced apart from the partition plate 61.

Since the source gas conduit 72 or the partition plate 61 thermally expands due to heat input from the reactor 10 to the gas introduction unit 12, the source gas conduit 72 and the partition plate 61 are not fixed by screws or the like. If the source gas conduit 72 and the partition plate 61 are fixed by screws or the like, the source gas conduit 72 and the partition plate 61 may crack due to differences in thermal expansion or strain, which is not preferable. Therefore, on the contact surface between the flange 72a and the partition plate 61, it is not possible to obtain complete airtightness between the source gas region 52 and the purge gas region 53.

The purge gas conduit 73 supplies the purge gas G3 to the reactor 10. The purge gas conduit 73 is inserted into the hole 60a. The purge gas conduit 73 passes through the rectifying plate 60.

The purge gas conduit 73 has an annular flange 73a at its upper end. The purge gas conduit 73 can be removed from the rectifying plate 60. The purge gas conduit 73 supports its own weight by placing the flange 73a on the rectifying plate 60. The outer wall of the purge gas conduit 73 is spaced apart from the rectifying plate 60.

The source gas conduit 72 is inserted inside the purge gas conduit 73. The purge gas conduit 73 and the source gas conduit 72 are spaced apart from each other. A flow path for the purge gas G3 is provided between the purge gas conduit 73 and the source gas conduit 72. In addition, the purge gas conduit 73 can be replaced with the hole 60a of the rectifying plate 60.

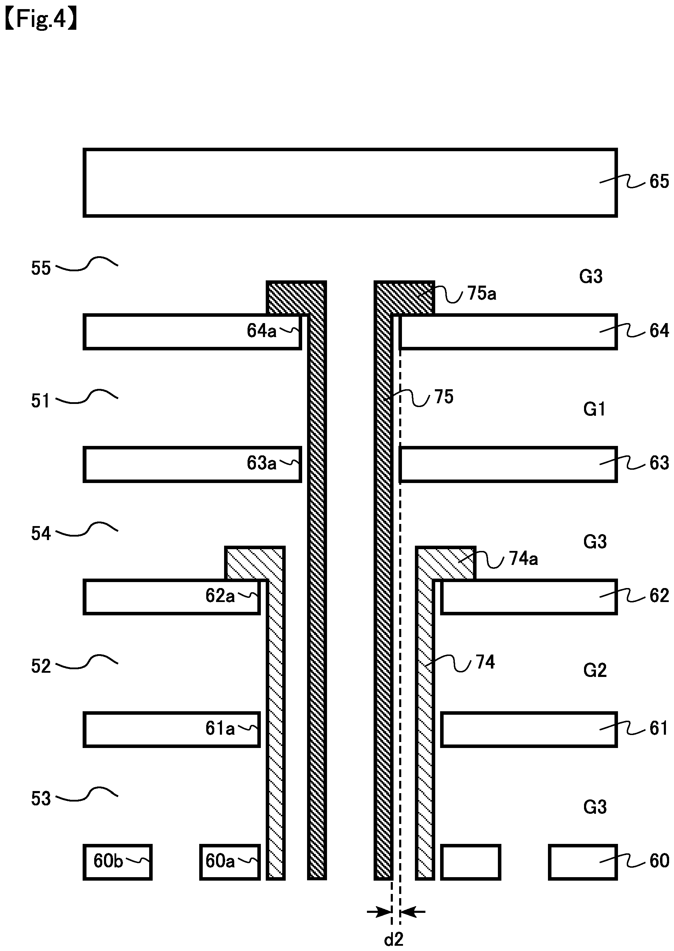

Fig. 4 is an enlarged schematic cross-sectional view of a part of a gas introduction unit of the vapor phase growth apparatus according to the first embodiment. Fig. 4 is a cross-sectional view including the purge gas conduit 75 and the purge gas conduit 74.

The purge gas conduit 75 supplies the purge gas G3 to the reactor. The purge gas conduit 75 is inserted into the holes 60a, 61a, 62a, 63a, and 64a. The purge gas conduit 75 passes through the rectifying plate 60 and the partition plates 61, 62, 63, and 64.

The purge gas conduit 75 has an annular flange 75a at its upper end. The purge gas conduit 75 can be removed from the partition plate 64. The purge gas conduit 75 supports its own weight by placing the flange 75a on the partition plate 64.

Since the purge gas conduit 75 or the partition plate 64 thermally expands due to heat input from the reactor 10 to the gas introduction unit 12, the purge gas conduit 75 and the partition plate 64 are not fixed by screws or the like. If the purge gas conduit 75 and the partition plate 64 are fixed by screws or the like, the purge gas conduit 75 and the partition plate 64 may crack due to differences in thermal expansion or strain, which is not preferable. Therefore, on the contact surface between the flange 75a and the partition plate 64, it is not possible to obtain complete airtightness between the purge gas region 55 and the source gas region 51.

The outer wall of the purge gas conduit 75 is spaced apart from the partition plate 63 and the partition plate 64. A distance (d2 in Fig. 4) between the outer wall of the purge gas conduit 75 and the partition plate 63 and a distance (d2 in Fig. 4) between the outer wall of the purge gas conduit 75 and the partition plate 64 are, for example, 100 µm or more and 1 mm or less. The distance d2 is a distance when the central axis of the purge gas conduit 75 and the center of the hole 63a are aligned. The distance d2 is a distance when the central axis of the purge gas conduit 75 and the center of the hole 64a are aligned.

A region between the outer wall of the purge gas conduit 75 and the partition plate 64 and a contact surface between the flange 75a and the partition plate 64 may function as a process gas leak path. For example, the source gas G1 introduced into the source gas region 51 may leak from the source gas region 51 to the purge gas region 55 through the contact surface between the flange 75a and the partition plate 64 and the region between the outer wall of the purge gas conduit 75 and the partition plate 64. Since the source gas G1 leaks into the purge gas region 55, the source gas G1 is mixed in the purge gas region 55.

The purge gas conduit 75 is inserted inside the purge gas conduit 74. The purge gas conduit 74 and the purge gas conduit 75 are spaced apart from each other. There is a gap between the purge gas conduit 74 and the purge gas conduit 75. The gap between the purge gas conduit 74 and the purge gas conduit 75 serves as a flow path for the purge gas G3.

The source gas conduits 71 and 72, the purge gas conduits 73, 74, and 75, and the gas cap 76 are formed of a highly heat-resistant material, such as SiC-coated carbon. In addition, the rectifying plate 60 and the partition plates 61, 62, 63, and 64 are formed of a highly heat-resistant material, such as SiC-coated carbon.

Next, a vapor phase growth method according to the first embodiment will be described. The vapor phase growth method according to the first embodiment is a vapor phase growth method using a vapor phase growth apparatus including a reactor, a holder provided in the reactor to place a substrate thereon, a source gas flow path configured to supply a source gas into the reactor, and a purge gas flow path configured to supply a purge gas into the reactor. The vapor phase growth method includes: supplying the source gas containing silicon and chlorine to the reactor through the source gas flow path; supplying a purge gas containing silicon and chlorine to the reactor through the purge gas flow path, an atomic concentration of silicon in the purge gas being lower than that in the source gas; and forming a silicon carbide film on a surface of the substrate.

In the vapor phase growth method according to the first embodiment, the vapor phase growth apparatus 100 shown in Fig. 1 is used. A case of forming a single crystal SiC film 11 (silicon carbide film) on the surface of the wafer W of single crystal SiC will be described as an example.

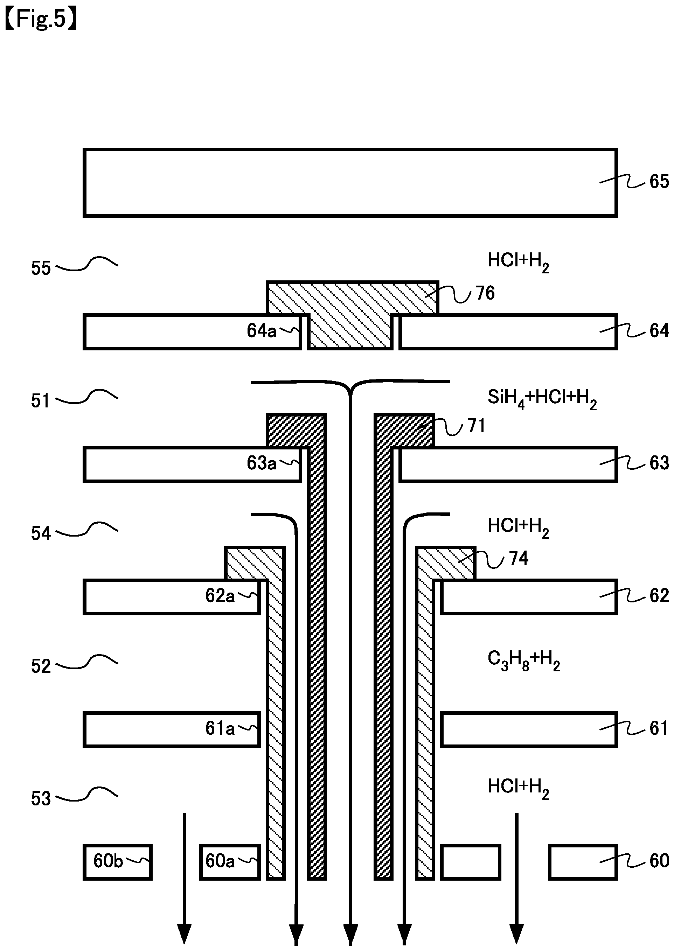

Figs. 5, 6, and 7 are explanatory diagrams of the vapor phase growth method according to the first embodiment.

First, the susceptor 14 on which the wafer W is placed is loaded into the reactor 10. The wafer W is single crystal SiC.

Then, the wafer W is rotated at a rotation speed of 300 rpm or more by the rotation driving mechanism 20. Then, the wafer W is heated by the first heater 22 and the second heater 42.

Then, the source gas G1 is introduced into the source gas region 51 through the source gas introduction port 81. In addition, the source gas G2 is introduced into the source gas region 52 through the source gas introduction port 82. In addition, the purge gas G3 is introduced into the purge gas regions 53, 54, and 55 through the purge gas introduction ports 83, 84, and 85.

Hereinafter, a case where the source gas G1 is a mixed gas of silane (SiH₄), hydrogen chloride (HCl), and hydrogen gas (H₂), the source gas G2 is a mixed gas of propane (C₃H₈) and hydrogen gas (H₂), and the purge gas G3 is a mixed gas of hydrogen chloride (HCl) and hydrogen gas (H₂) will be described as an example.

As will be described later, the source gas G1 from the source gas region 51 is easily mixed into the purge gas region 54 through a region between the outer wall of the source gas conduit 71 and the partition plate 63 and a contact surface between the flange 71a and the partition plate 63. In addition, the source gas G1 from the source gas region 51 is easily mixed into the purge gas region 55 through a region between the outer wall of the purge gas conduit 75 and the partition plate 64 and a contact surface between the flange 75a and the partition plate 64. Therefore, the purge gas regions 54 and 55 tend to contain a small amount of silane. That is, the purge gas regions 54 and 55 may contain a small amount of silicon.

The atomic concentration of silicon in the purge gas G3 in the purge gas regions 54 and 55 is lower than the atomic concentration of silicon in the source gas G1 in the source gas region 51. The atomic concentration of silicon in the purge gas G3 in the purge gas regions 54 and 55 is, for example, 1/100 or less of the atomic concentration of silicon in the source gas G1 in the source gas region 51.

As shown in Fig. 5, a mixed gas of silane, hydrogen chloride, and hydrogen gas that is supplied as the source gas G1 is supplied from the source gas region 51 to the reactor 10 through the source gas conduit 71. The source gas region 51 and the source gas conduit 71 form a source gas flow path for the source gas G1. The source gas flow path for the source gas G1 is an example of a first source gas flow path.

In addition, as shown in Fig. 5, a mixed gas of hydrogen chloride and hydrogen gas, which is the purge gas G3, is supplied from the purge gas region 54 to the reactor 10 through the purge gas conduit 74. The purge gas G3 is supplied to the reactor 10 through the gap between the purge gas conduit 74 and the source gas conduit 71. The purge gas region 54 and the purge gas conduit 74 form a purge gas flow path for the purge gas G3.

In addition, as shown in Fig. 5, a mixed gas of hydrogen chloride and hydrogen gas, which is the purge gas G3, is supplied from the purge gas region 53 to the reactor 10 through the holes 60b of the rectifying plate 60.

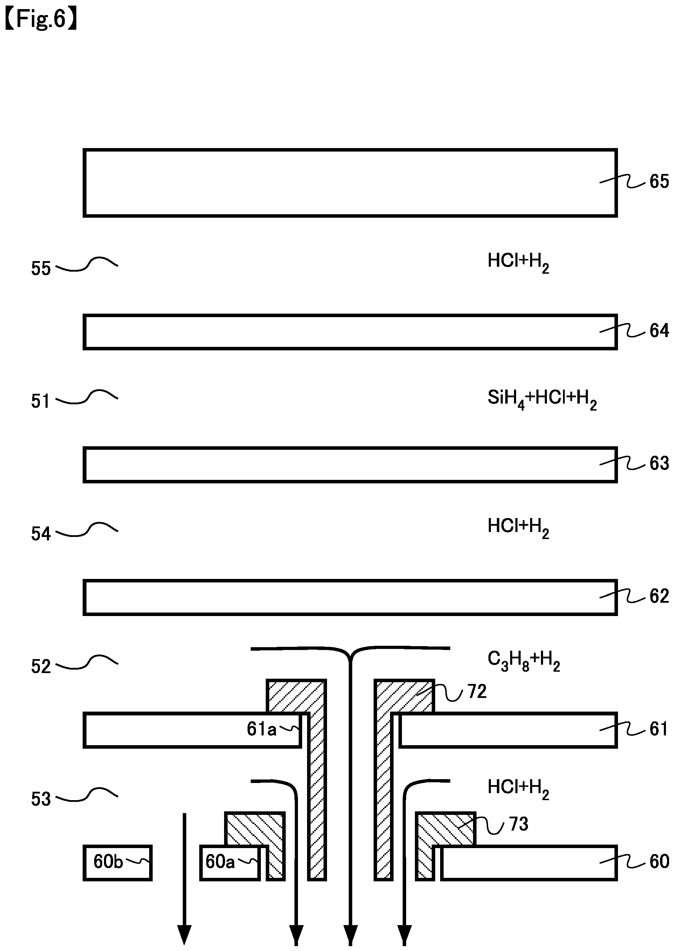

As shown in Fig. 6, a mixed gas of propane and hydrogen gas, which is the source gas G2, is supplied from the source gas region 52 to the reactor 10 through the source gas conduit 72. The source gas region 52 and the source gas conduit 72 form a source gas flow path for the source gas G2. The source gas flow path for the source gas G2 is an example of a second source gas flow path.

In addition, as shown in Fig. 6, a mixed gas of hydrogen chloride and hydrogen gas, which is the purge gas G3, is supplied from the purge gas region 53 to the reactor 10 through the purge gas conduit 73.

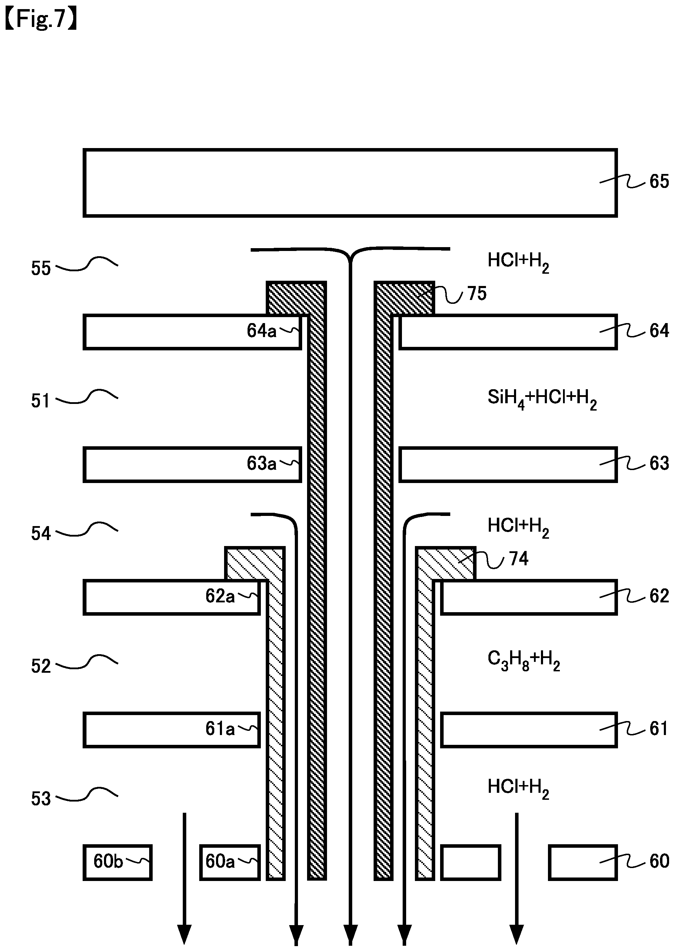

As shown in Fig. 7, a mixed gas of hydrogen chloride and hydrogen gas, which is the purge gas G3, is supplied from the purge gas region 55 to the reactor 10 through the purge gas conduit 75. The purge gas region 55 and the purge gas conduit 75 form a purge gas flow path for the purge gas G3. In addition, a mixed gas of hydrogen chloride and hydrogen gas, which is the purge gas G3, is supplied from the purge gas region 54 to the reactor 10 through the purge gas conduit 74. The purge gas region 54 and the purge gas conduit 74 form a purge gas flow path for the purge gas G3.

The source gas G1, the source gas G2, and the purge gas G3 supplied from the gas introduction unit 12 to the reactor 10 form a gas flow toward the surface of the wafer W. Si atoms contained in the source gas G1 and C atoms contained in the source gas G2 react on the surface of the wafer W, so that the single crystal SiC film 11 is formed on the surface of the wafer W.

After forming the SiC film 11, the heating by the first heater 22 and the second heater 42 is stopped to lower the temperature of the wafer W. Thereafter, the wafer W is unloaded from the reactor 10 together with the susceptor 14.

Next, the function and effect of the vapor phase growth method and the vapor phase growth apparatus according to the first embodiment will be described.

In the vapor phase growth apparatus 100 according to the first embodiment, as shown in Fig. 5, the source gas conduit 71 is inserted inside the purge gas conduit 74. The source gas conduit 71 and the purge gas conduit 74 have a double tube structure.

When the source gas G1 is supplied from the source gas conduit 71 to the reactor 10, the purge gas G3 is supplied from the purge gas conduit 74 to the reactor 10 so as to surround the source gas G1.

In the vapor phase growth apparatus 100 according to the first embodiment, as shown in Fig. 6, the source gas conduit 72 is inserted inside the purge gas conduit 73. The source gas conduit 72 and the purge gas conduit 73 have a double tube structure.

When the source gas G2 is supplied from the source gas conduit 72 to the reactor 10, the purge gas G3 is supplied from the purge gas conduit 73 to the reactor 10 so as to surround the source gas G2.

In the vapor phase growth apparatus 100 according to the first embodiment, as shown in Fig. 2, the outer wall of the source gas conduit 71 is spaced apart from the partition plate 63 by the distance d1. Therefore, for example, even if the source gas conduit 71 is heated from the end on the reactor 10 side by the heater 42 and thermally expands, damage to the source gas conduit 71 or the partition plate 63 is suppressed.

In addition, in the vapor phase growth apparatus 100 according to the first embodiment, as shown in Fig. 4, the outer wall of the purge gas conduit 75 is spaced apart from each of the partition plates 63 and 64 by the distance d2. Therefore, for example, even if the purge gas conduit 75 is heated from the end on the reactor 10 side by the second heater 42 and thermally expands, damage to the purge gas conduit 75 or the partition plates 63 and 64 is suppressed.

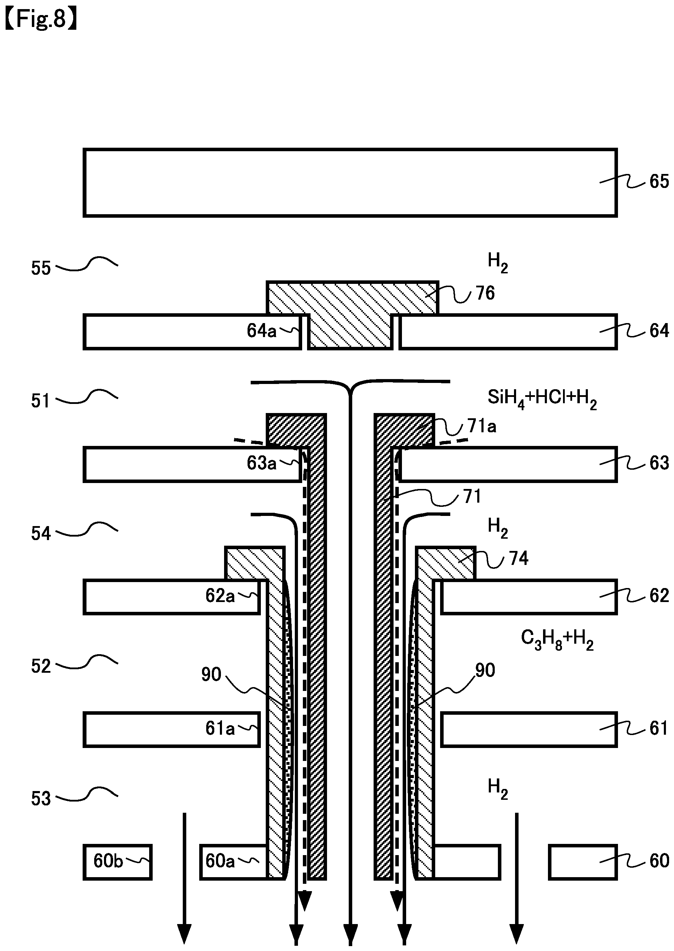

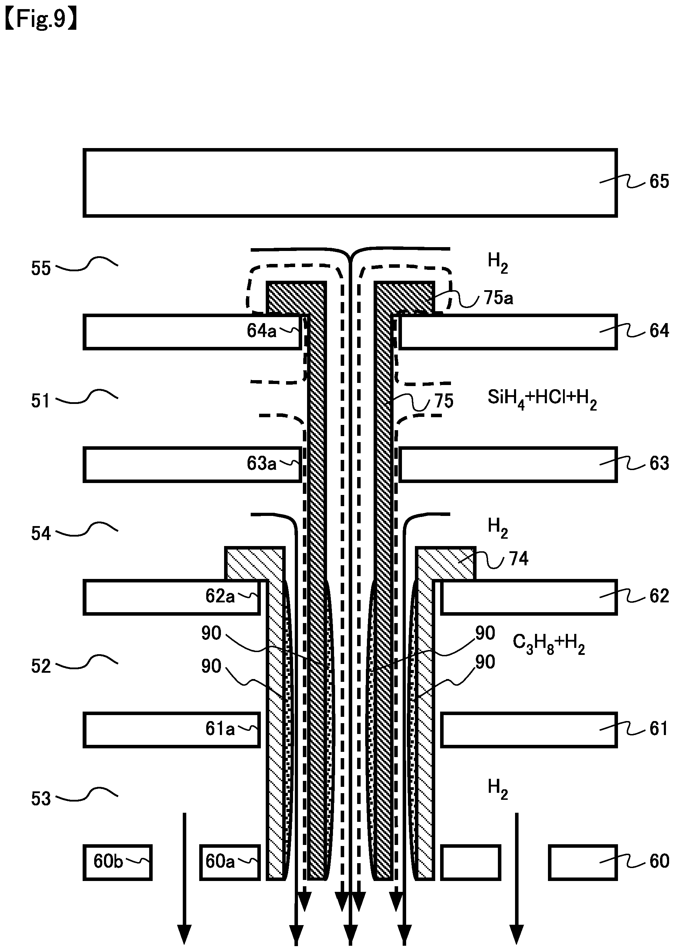

Figs. 8 and 9 are explanatory diagrams of the function and effect of the vapor phase growth apparatus according to the first embodiment. Fig. 8 is a diagram corresponding to Fig. 5. Fig. 9 is a diagram corresponding to Fig. 6.

The configuration shown in Fig. 8 is different from the vapor phase growth apparatus 100 according to the first embodiment in that the purge gas G3 does not contain chlorine. The purge gas G3 is, for example, a hydrogen gas.

As shown in Fig. 8, the contact surface between the flange 71a and the partition plate 63 and the region between the outer wall of the source gas conduit 71 and the partition plate 63 may function as a gas leak path. That is, as indicated by the dotted arrow in Fig. 8, the source gas G1 may leak from the source gas region 51 to the purge gas region 54 through the region between the outer wall of the source gas conduit 71 and the partition plate 63. Since the source gas G1 leaks into the purge gas region 54, the source gas G1 is mixed in the purge gas region 54.

Since the mixed gas of silane, hydrogen chloride, and hydrogen gas, which is the source gas G1, is mixed in the purge gas region 54, silicon-containing by-products 90 are deposited between the source gas conduit 71 and the purge gas conduit 74 as shown in Fig. 8.

The deposition of the silicon-containing by-products 90 between the source gas conduit 71 and the purge gas conduit 74 means that the atomic concentration of silicon contained in the gas supplied to the reactor 10 through the purge gas conduit 74 is reduced. That is, the amount of silicon supplied to the reactor 10 is reduced. Therefore, the amount of silicon supplied to the surface of the wafer W is also reduced. In addition, when the silicon-containing by-products 90 are deposited between the source gas conduit 71 and the purge gas conduit 74, the reaction between the silicon contained in the gas supplied to the reactor 10 through the purge gas conduit 74 and the silicon-containing by-products 90 is accelerated, so that the atomic concentration of silicon contained in the gas supplied to the reactor 10 through the purge gas conduit 74 decreases over time. Therefore, the reproducibility of the characteristics of the SiC film 11 formed on the surface of the wafer W is degraded. For example, the reproducibility of the thickness of the SiC film 11 or the reproducibility of the carrier concentration is degraded.

The configuration shown in Fig. 9 is different from the vapor phase growth apparatus 100 according to the first embodiment in that the purge gas G3 does not contain chlorine. The purge gas G3 is, for example, a hydrogen gas.

As shown in Fig. 9, the contact surface between the flange 75a and the partition plate 64 and the region between the outer wall of the purge gas conduit 75 and the partition plate 64 may function as a gas leak path. In addition, the region between the outer wall of the purge gas conduit 75 and the partition plate 63 may function as a gas leak path. That is, as indicated by the dotted arrow in Fig. 9, the source gas G1 may leak from the source gas region 51 to the purge gas regions 54 and 55 through the region between the outer wall of the purge gas conduit 75 and the partition plate 64 and the region between the outer wall of the purge gas conduit 75 and the partition plate 63. Since the source gas G1 leaks into the purge gas regions 54 and 55, the source gas G1 is mixed in the purge gas regions 54 and 55.

In particular, since the purge gas conduit 75 has the flange 75a in contact with the partition plate 64, it is not possible to provide a flange in contact with the partition plate 63 at the same time due to processing accuracy or thermal deformation. Therefore, for example, the amount of leakage increases compared with the case shown in Fig. 8, and the amount of the source gas G1 mixed in the purge gas region 54 increases.

Since the mixed gas of silane, hydrogen chloride, and hydrogen gas, which is the source gas G1, is mixed in the purge gas regions 54 and 55, the silicon-containing by-products 90 are deposited inside the purge gas conduit 75 and between the purge gas conduit 75 and the purge gas conduit 74 as shown in Fig. 9.

When the silicon-containing by-products 90 are deposited inside the purge gas conduit 75 or between the purge gas conduit 75 and the purge gas conduit 74, the amount of silicon supplied to the reactor 10 is reduced. Therefore, the amount of silicon supplied to the surface of the wafer W is also reduced. In addition, when the silicon-containing by-products 90 are deposited inside the purge gas conduit 75 or between the purge gas conduit 75 and the purge gas conduit 74, the reaction between the silicon contained in the gas supplied to the reactor 10 through the purge gas conduit 75 or the purge gas conduit 74 and the silicon-containing by-products 90 is accelerated, so that the atomic concentration of silicon contained in the gas supplied to the reactor 10 through the purge gas conduit 75 or the purge gas conduit 74 decreases over time. Therefore, the reproducibility of the characteristics of the SiC film 11 formed on the surface of the wafer W is degraded. For example, the reproducibility of the thickness of the SiC film 11 or the reproducibility of the carrier concentration is degraded.

In the vapor phase growth apparatus 100 and the vapor phase growth method according to the first embodiment, the purge gas G3 contains chlorine. The purge gas G3 is, for example, a mixed gas of hydrogen chloride (HCl) and hydrogen gas (H₂).

Since the purge gas G3 contains chlorine, even if a gas containing silicon is mixed in the purge gas regions 54 and 55 due to leakage of the source gas G1, silicon by-products are etched by chlorine. Therefore, the deposition of the silicon-containing by-products 90 in the gas flow path to the reactor 10 is suppressed. As a result, the reproducibility of the characteristics of the SiC film 11 formed on the surface of the wafer W is improved. For example, the reproducibility of the thickness of the SiC film 11 or the reproducibility of the carrier concentration is improved.

The atomic concentration of silicon in the purge gas G3 in the purge gas regions 54 and 55 after mixing with the source gas G1 is lower than the atomic concentration of silicon in the source gas G1. In addition, the atomic concentration of chlorine in the purge gas G3 after mixing with the source gas G1 is lower than the atomic concentration of chlorine in the source gas G1.

From the viewpoint of suppressing the clustering of silicon, the atomic concentration of chlorine in the source gas G1 is preferably twice or more the atomic concentration of silicon in the source gas G1, more preferably five times or more.

In addition, from the viewpoint of suppressing a decrease in the growth rate of the SiC film 11, it is preferable that the atomic concentration of chlorine in the purge gas G3 is lower than the atomic concentration of chlorine in the source gas G1. The atomic concentration of chlorine in the purge gas G3 is preferably one-half or less of the atomic concentration of chlorine in the source gas G1, more preferably one-fifth or less.

From the viewpoint of suppressing the formation of the silicon-containing by-products 90, the atomic concentration of chlorine in the purge gas G3 is preferably 1/100 or more of the atomic concentration of chlorine in the source gas G1, more preferably 1/50 or more.

From the viewpoint of suppressing damage to the source gas conduit 71 or the partition plate 63, the distance d1 between the outer wall of the source gas conduit 71 and the partition plate 63 is preferably 100 µm or more, more preferably 250 µm or more.

From the viewpoint of suppressing misalignment of the central axes of the source gas conduit 71 and the purge gas conduit 74, the distance d1 between the outer wall of the source gas conduit 71 and the third partition plate 63 is preferably 1 mm or less, more preferably 750 µm or less.

### (Modification Example)

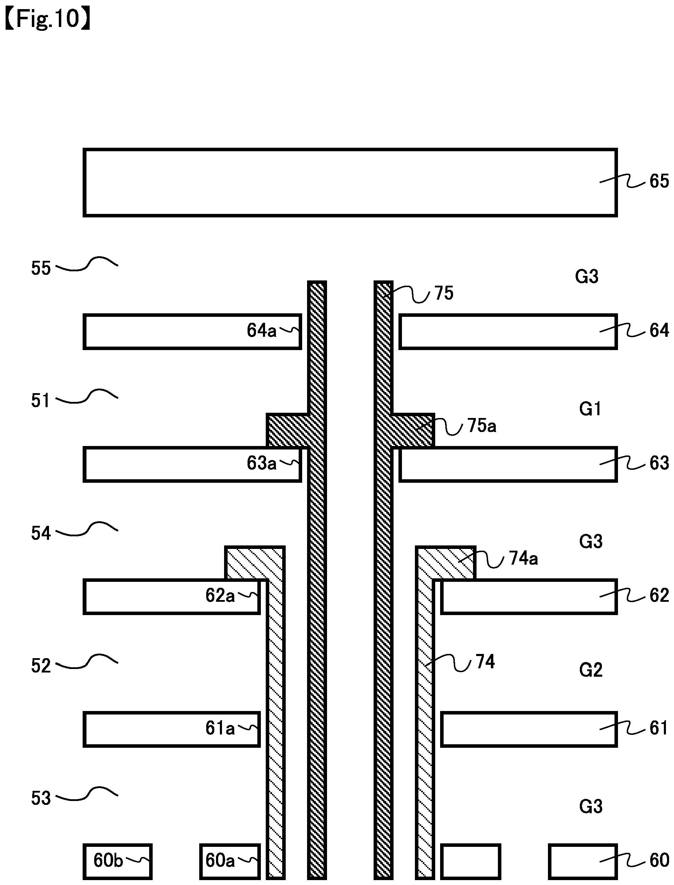

Fig. 10 is an enlarged schematic cross-sectional view of a part of a gas introduction unit of a modification example of the vapor phase growth apparatus according to the first embodiment. Fig. 10 is a cross-sectional view including the purge gas conduits 75 and 74. Fig. 10 is a cross-sectional view corresponding to Fig. 4.

The purge gas conduit 75 supplies the purge gas G3 to the reactor. The purge gas conduit 75 is inserted into the holes 60a, 61a, 62a, 63a, and 64a. The purge gas conduit 75 passes through the rectifying plate 60 and the partition plates 61, 62, 63, and 64.

The purge gas conduit 75 has an annular flange 75a between its upper and lower ends. The purge gas conduit 75 can be removed from the partition plate 63. The purge gas conduit 75 supports its own weight by placing the flange 75a on the partition plate 63.

The outer wall of the purge gas conduit 75 is spaced apart from the partition plates 63 and 64. There is a gap between the purge gas conduit 75 and the partition plates 63 and 64.

The purge gas conduit 75 is inserted inside the purge gas conduit 74. The purge gas conduit 74 and the purge gas conduit 75 are spaced apart from each other. The gap between the purge gas conduit 74 and the purge gas conduit 75 serves as a flow path for the purge gas G3.

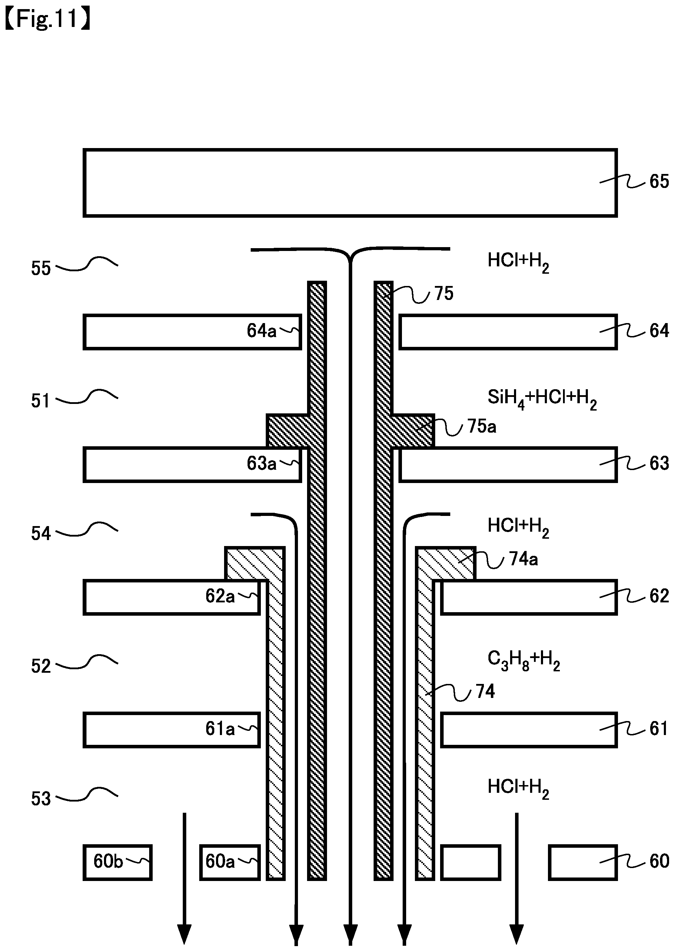

Fig. 11 is an explanatory diagram of a modification example of the vapor phase growth method according to the first embodiment.

When forming the SiC film 11 on the surface of the wafer W, as shown in Fig. 11, a mixed gas of hydrogen chloride and hydrogen gas, which is the purge gas G3, is supplied from the purge gas region 55 to the reactor 10 through the purge gas conduit 75. In addition, a mixed gas of hydrogen chloride and hydrogen gas, which is the purge gas G3, is supplied from the purge gas region 54 to the reactor 10 through the purge gas conduit 74.

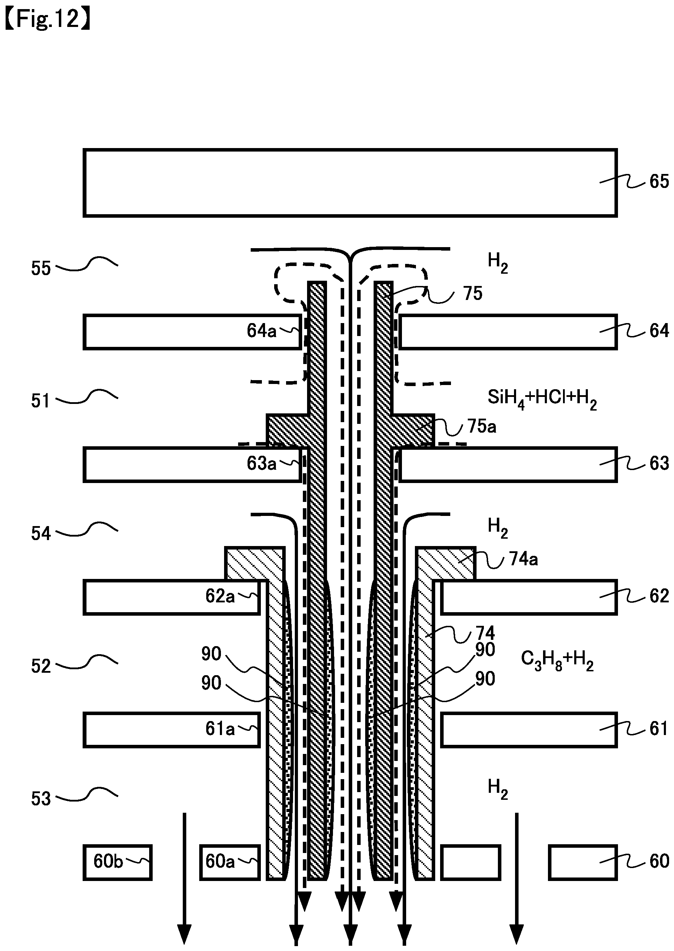

Fig. 12 is an explanatory diagram of the function and effect of the modification example of the vapor phase growth apparatus according to the first embodiment. Fig. 12 is a diagram corresponding to Fig. 11.

Fig. 12 is different from the modification example of the vapor phase growth apparatus 100 according to the first embodiment in that the purge gas G3 does not contain chlorine. The purge gas G3 is, for example, a hydrogen gas.

As shown in Fig. 12, the contact surface between the flange 75a and the partition plate 63 and the region between the outer wall of the purge gas conduit 75 and the partition plate 63 may function as a gas leak path. In addition, the region between the outer wall of the purge gas conduit 75 and the partition plate 64 may function as a gas leak path. That is, as indicated by the dotted arrow in Fig. 12, the source gas G1 may leak from the source gas region 51 to the purge gas regions 54 and 55 through the region between the outer wall of the purge gas conduit 75 and the partition plate 63 and the region between the outer wall of the purge gas conduit 75 and the partition plate 64. Since the source gas G1 leaks into the purge gas regions 54 and 55, the source gas G1 is mixed in the purge gas regions 54 and 55.

In particular, since the purge gas conduit 75 has the flange 75a in contact with the partition plate 63, it is not possible to provide a flange in contact with the partition plate 64 at the same time due to processing accuracy or thermal deformation. Therefore, for example, the amount of the source gas G1 mixed with the purge gas G3 in the purge gas region 55 is increased compared with the case shown in Fig. 9.

Since the mixed gas of silane, hydrogen chloride, and hydrogen gas, which is the source gas G1, is mixed in the purge gas regions 54 and 55, the silicon-containing by-products 90 are deposited inside the purge gas conduit 75 and between the purge gas conduit 75 and the purge gas conduit 74 as shown in Fig. 12.

When the silicon-containing by-products 90 are deposited inside the purge gas conduit 75 or between the purge gas conduit 75 and the purge gas conduit 74, the amount of silicon supplied to the reactor 10 is reduced. Therefore, the amount of silicon supplied to the surface of the wafer W is also reduced. In addition, when the silicon-containing by-products 90 are deposited inside the purge gas conduit 75 or between the purge gas conduit 75 and the purge gas conduit 74, the reaction between the silicon contained in the gas supplied to the reactor 10 through the purge gas conduit 75 or the purge gas conduit 74 and the silicon-containing byproduct 90 is accelerated, so that the atomic concentration of silicon contained in the gas supplied to the reactor 10 through the purge gas conduit 75 or the purge gas conduit 74 decreases over time. Therefore, the reproducibility of the characteristics of the SiC film 11 formed on the surface of the wafer W is degraded.

In the modification examples of the vapor phase growth apparatus 100 and the vapor phase growth method according to the first embodiment, the purge gas G3 contains chlorine. The purge gas G3 is, for example, a mixed gas of hydrogen chloride (HCl) and hydrogen gas (H₂).

Since the purge gas G3 contains chlorine, even if a gas containing silicon is mixed in the purge gas regions 54 and 55 due to leakage of the source gas G1, silicon by-products are etched by chlorine. Therefore, the deposition of the silicon-containing by-products 90 in the gas flow path is suppressed. As a result, the reproducibility of the characteristics of the SiC film 11 formed on the surface of the wafer W is improved. For example, the reproducibility of the thickness of the SiC film 11 or the reproducibility of the carrier concentration is improved.

As described above, according to the vapor phase growth apparatus and the vapor phase growth method according to the first embodiment and its modification examples, the deposition of silicon-containing by-products in the gas flow path can be suppressed. Therefore, according to the vapor phase growth apparatus and the vapor phase growth method according to the first embodiment, it is possible to improve the reproducibility of the film characteristics.

### (Second Embodiment)

A vapor phase growth apparatus and a vapor phase growth method according to a second embodiment are different from the vapor phase growth apparatus and the vapor phase growth method according to the first embodiment in that one kind of source gas is used. Hereinafter, the description of a part of the content overlapping the first embodiment may be omitted.

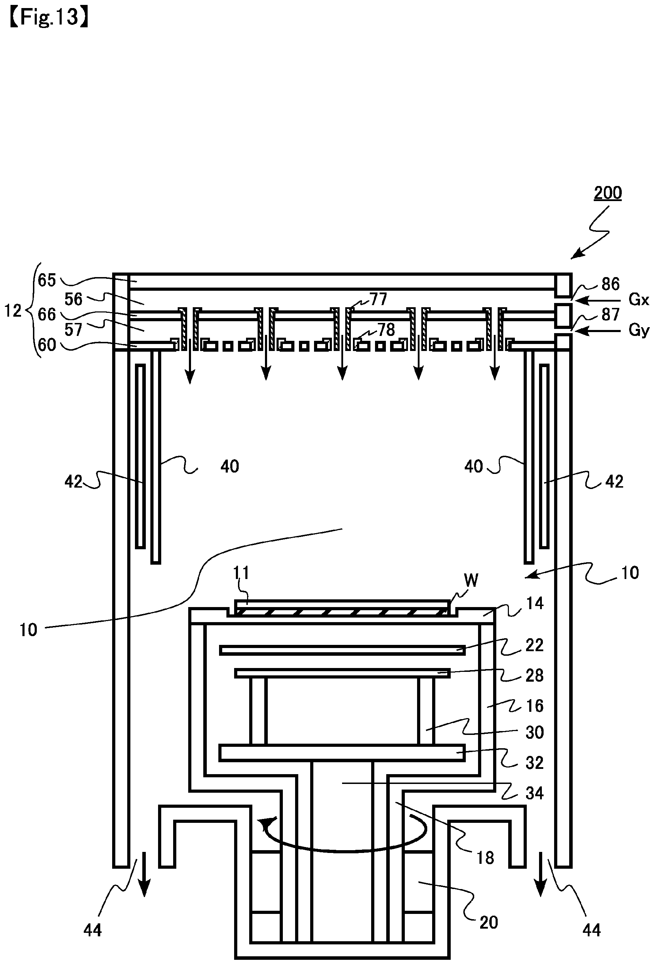

Fig. 13 is a schematic cross-sectional view of the vapor phase growth apparatus according to the second embodiment. A vapor phase growth apparatus 200 according to the second embodiment is, for example, a single wafer type epitaxial growth apparatus that epitaxially grows a single crystal SiC film on a single crystal SiC substrate. The vapor phase growth apparatus 200 according to the second embodiment is a vertical vapor phase growth apparatus in which a process gas is supplied in a vertical direction to the surface of the SiC substrate.

The vapor phase growth apparatus 200 according to the second embodiment includes a reactor 10 and a gas introduction unit 12. The reactor 10 includes a susceptor 14 (holder), a rotating body 16, a rotating shaft 18, a rotation driving mechanism 20, a first heater 22, a reflector 28, a support column 30, a fixing table 32, a fixing shaft 34, a hood 40, a second heater 42, and a gas discharge port 44. The gas introduction unit 12 includes a source gas region 56, a purge gas region 57, a rectifying plate 60, a partition plate 66, a top plate 65, a source gas conduit 77, a purge gas conduit 78, a source gas introduction port 86, and a purge gas introduction port 87.

The susceptor 14 is an example of a holder. The rectifying plate 60 is an example of a second partition plate. The partition plate 66 is an example of a first partition plate.

The source gas region 56 and the source gas conduit 77 form a first source gas flow path. The purge gas region 57 and the purge gas conduit 78 form a purge gas flow path.

The gas introduction unit 12 is provided above the reactor 10.

In the gas introduction unit 12, the source gas introduction port 86 for introducing a source gas Gx into the gas introduction unit 12 is provided. The source gas Gx is introduced into the source gas region 56 through the source gas introduction port 86.

In the gas introduction unit 12, the purge gas introduction port 87 for introducing the purge gas Gy into the gas introduction unit 12 are provided. The purge gas Gy is introduced into the purge gas region 57 through the purge gas introduction port 87.

The source gas Gx is an example of a first source gas.

The source gas Gx contains silicon (Si), carbon (C), and chlorine (Cl). The source gas Gx is, for example, a mixed gas of silane (SiH₄), propane (C₃H₈), hydrogen chloride (HCl), and hydrogen gas (H₂).

Hydrogen chloride (HCl) is an assist gas for suppressing the clustering of silicon. In addition, hydrogen chloride has a function of etching silicon-containing by-products deposited in the gas flow path for the source gas Gx.

The hydrogen gas (H₂) is a carrier gas. As the carrier gas, for example, an argon gas (Ar) can also be used.

The source gas Gx contains, for example, a dopant gas of n-type impurities. The dopant gas of n-type impurities is, for example, a nitrogen gas.

The purge gas Gy has a function of stabilizing the flow of the source gas Gx inside the reactor 10. The purge gas Gy contains chlorine (Cl). The purge gas Gy contains, for example, hydrogen chloride (HCl). The purge gas Gy is, for example, a mixed gas of hydrogen chloride (HCl) and hydrogen gas (H₂).

Hydrogen chloride (HCl) is a gas for etching silicon-containing by-products. Instead of the hydrogen gas (H₂), for example, an argon gas (Ar) can be used.

The atomic concentration of chlorine in the purge gas Gy is, for example, lower than the atomic concentration of chlorine in the source gas Gx. The atomic concentration of chlorine in the purge gas Gy is, for example, one-fifth or less of the atomic concentration of chlorine in the source gas Gx.

The source gas Gx is introduced into the source gas region 56.

The purge gas Gy is introduced into the purge gas region 57. The purge gas region 57 is provided between the source gas region 56 and the reactor 10.

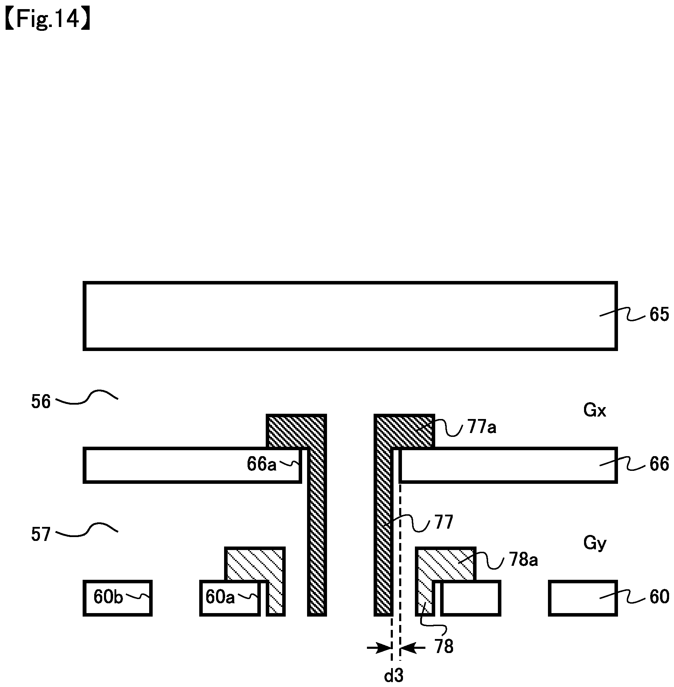

Fig. 14 is an enlarged schematic cross-sectional view of a part of a gas introduction unit of the vapor phase growth apparatus according to the second embodiment. Fig. 14 is a cross-sectional view including the source gas conduit 77 and the purge gas conduit 78.

The rectifying plate 60 is provided between the reactor 10 and the purge gas region 57. The rectifying plate 60 has a plurality of holes 60a and a plurality of holes 60b. The purge gas conduit 78 and the source gas conduit 77 are provided inside the hole 60a. The purge gas conduit 78 can be replaced with the hole 60a of the rectifying plate 60.

The partition plate 66 is provided between the purge gas region 57 and the source gas region 56. The partition plate 66 has a plurality of holes 66a. The source gas conduit 77 is provided inside the hole 66a.

The source gas conduit 77 supplies the source gas Gx to the reactor 10. The source gas conduit 77 is inserted into the holes 60a and 66a. The source gas conduit 77 passes through the rectifying plate 60 and the partition plate 66.

The source gas conduit 77 has an annular flange 77a at its upper end. The source gas conduit 77 can be removed from the partition plate 66.

The outer wall of the source gas conduit 77 is spaced apart from the partition plate 66. There is a gap between the source gas conduit 77 and the partition plate 66. A distance (d3 in Fig. 14) between the outer wall of the source gas conduit 77 and the partition plate 66 is, for example, 10 µm or more and 100 µm or less. The distance d3 is a distance when the central axis of the source gas conduit 77 and the center of the hole 66a are aligned.

The purge gas conduit 78 supplies the purge gas Gy to the reactor 10. The purge gas conduit 78 is inserted into the hole 60a. The purge gas conduit 78 passes through the rectifying plate 60.

The purge gas conduit 78 has an annular flange 78a at its upper end. The purge gas conduit 78 can be removed from the rectifying plate 60. The outer wall of the purge gas conduit 78 is spaced apart from the rectifying plate 60.

The source gas conduit 77 is inserted inside the purge gas conduit 78. The purge gas conduit 78 and the source gas conduit 77 are spaced apart from each other. The gap between the purge gas conduit 78 and the source gas conduit 77 serves as a flow path for the purge gas Gy.

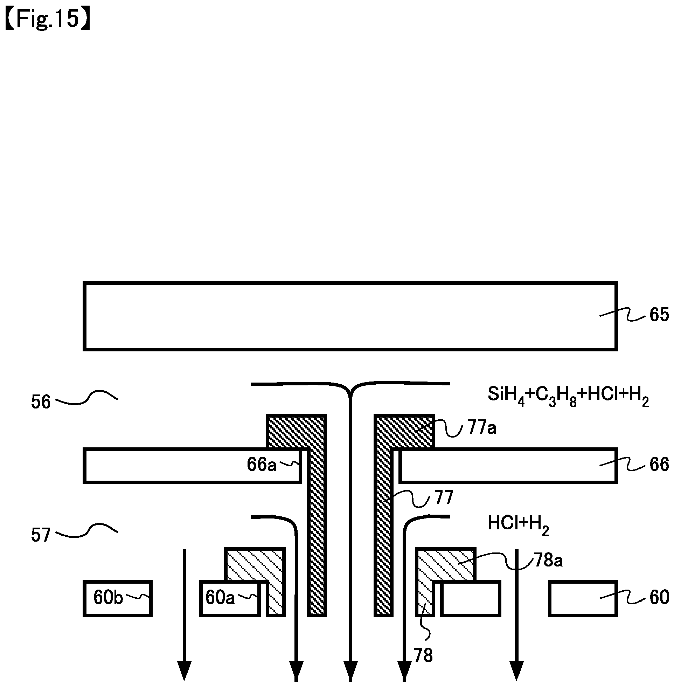

Fig. 15 is an explanatory diagram of the vapor phase growth method according to the second embodiment.

Hereinafter, a case where the source gas Gx is a mixed gas of silane (SiH₄), propane (C₃H₈), hydrogen chloride (HCl), and hydrogen gas (H₂) and the purge gas Gy is a mixed gas of hydrogen chloride (HCl) and hydrogen gas (H₂) will be described as an example.

As shown in Fig. 15, a mixed gas of silane, propane, hydrogen chloride, and hydrogen gas, which is the source gas Gx, is supplied from the source gas region 56 to the reactor 10 through the source gas conduit 77.

In addition, as shown in Fig. 15, a mixed gas of hydrogen chloride and hydrogen gas, which is the purge gas Gy, is supplied from the purge gas region 57 to the reactor 10 through the purge gas conduit 78.

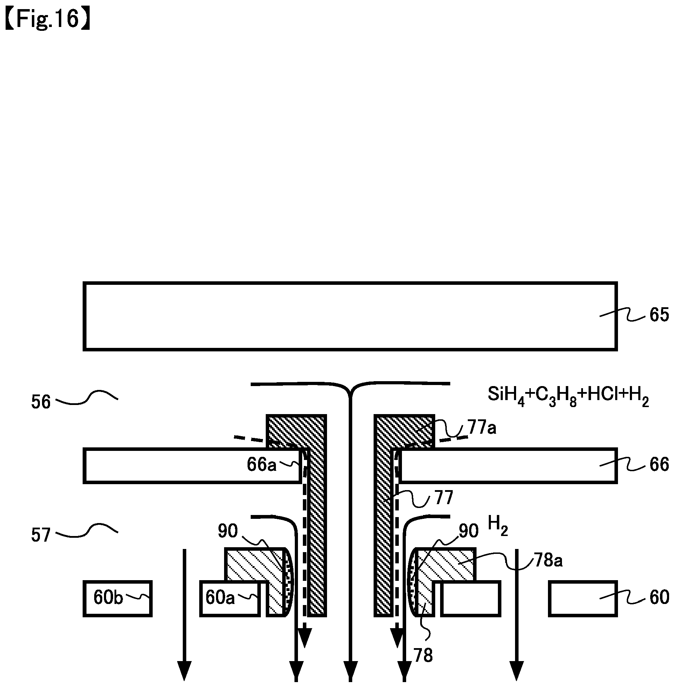

Fig. 16 is an explanatory diagram of the function and effect of the vapor phase growth apparatus according to the second embodiment. Fig. 16 is a diagram corresponding to Fig. 15.

The configuration shown in Fig. 16 is different from the vapor phase growth apparatus 200 according to the second embodiment in that the purge gas Gy does not contain chlorine. The purge gas Gy is, for example, a hydrogen gas.

As shown in Fig. 16, the contact surface between the flange 77a and the partition plate 66 and the region between the outer wall of the source gas conduit 77 and the partition plate 66 may function as a gas leak path. That is, as indicated by the dotted arrow in Fig. 16, the source gas Gx may leak from the source gas region 56 to the purge gas region 57 through the region between the outer wall of the source gas conduit 77 and the partition plate 66. Since the source gas Gx leaks into the purge gas region 57, the source gas Gx is mixed in the purge gas region 57.

Since the mixed gas of silane, propane, hydrogen chloride, and hydrogen gas, which is the source gas Gx, is mixed in the purge gas region 57, the silicon-containing by-products 90 are deposited between the source gas conduit 77 and the purge gas conduit 78 as shown in Fig. 16.

The deposition of the silicon-containing by-products 90 between the source gas conduit 77 and the purge gas conduit 78 means that the atomic concentration of silicon contained in the gas supplied to the reactor 10 through the purge gas conduit 78 is reduced. That is, the amount of silicon supplied to the reactor 10 is reduced. Therefore, the amount of silicon supplied to the surface of the wafer W is also reduced. In addition, when the silicon-containing by-products 90 are deposited between the source gas conduit 77 and the purge gas conduit 78, the reaction between the silicon contained in the gas supplied to the reactor 10 through the purge gas conduit 78 and the silicon-containing by-products 90 is accelerated, so that the atomic concentration of silicon contained in the gas supplied to the reactor 10 through the purge gas conduit 78 decreases over time. Therefore, the reproducibility of the characteristics of the SiC film 11 formed on the surface of the wafer W is degraded. For example, the reproducibility of the thickness of the SiC film 11 or the reproducibility of the carrier concentration is degraded.

The atomic concentration of silicon in the purge gas Gy in the purge gas region 57 after mixing with the source gas Gx is lower than the atomic concentration of silicon in the source gas Gx. In addition, the atomic concentration of chlorine in the purge gas Gy after mixing with the source gas Gx is lower than the atomic concentration of chlorine in the source gas Gx.

From the viewpoint of suppressing the clustering of silicon, the atomic concentration of chlorine in the source gas Gx is preferably twice or more the atomic concentration of silicon in the source gas Gx, more preferably five times or more.

From the viewpoint of reducing the defect density of the SiC film 11 and suppressing a decrease in the growth rate of the SiC film 11, it is preferable that the atomic concentration of chlorine in the purge gas Gy is lower than the atomic concentration of chlorine in the source gas Gx. The atomic concentration of chlorine in the purge gas Gy is preferably one-half or less of the atomic concentration of chlorine in the source gas Gx, more preferably one-fifth or less.

From the viewpoint of suppressing the formation of the silicon-containing by-products 90, the atomic concentration of chlorine in the purge gas Gy is preferably 1/100 or more of the atomic concentration of chlorine in the source gas Gx, more preferably 1/50 or more.

From the viewpoint of suppressing damage to the source gas conduit 77 or the partition plate 66, the distance d3 between the outer wall of the source gas conduit 77 and the partition plate 66 is preferably 100 µm or more, more preferably 250 µm or more.

From the viewpoint of suppressing misalignment of the central axes of the source gas conduit 77 and the purge gas conduit 78, the distance d3 between the outer wall of the source gas conduit 77 and the partition plate 66 is preferably 1 mm or less, more preferably 750 µm or less.

As described above, according to the vapor phase growth apparatus and the vapor phase growth method according to the second embodiment, the deposition of silicon-containing by-products in the gas flow path can be suppressed. Therefore, according to the vapor phase growth apparatus and the vapor phase growth method according to the second embodiment, it is possible to improve the reproducibility of the film characteristics.

### (Third Embodiment)

A vapor phase growth apparatus and a vapor phase growth method according to a third embodiment are different from the vapor phase growth apparatus and the vapor phase growth method according to the second embodiment in that the vapor phase growth apparatus is a horizontal vapor phase growth apparatus. Hereinafter, the description of a part of the content overlapping the first or second embodiment may be omitted.

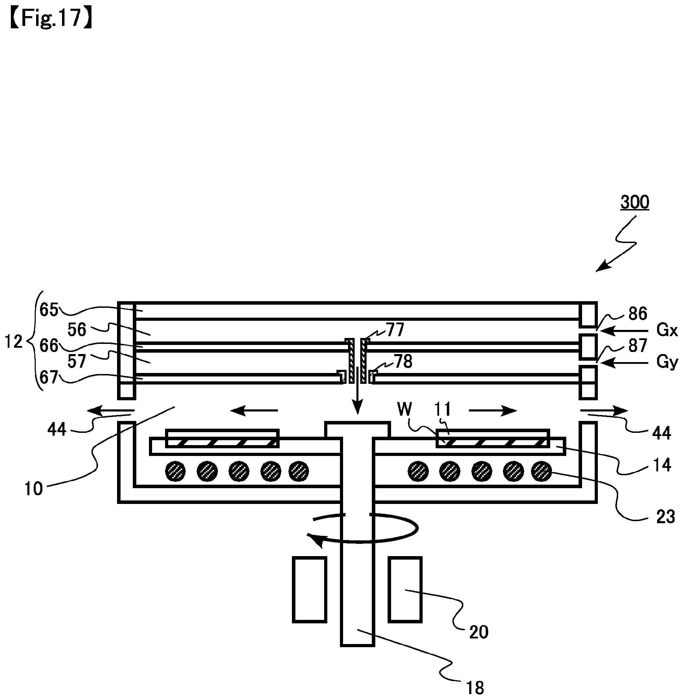

Fig. 17 is a schematic cross-sectional view of the vapor phase growth apparatus according to the third embodiment. A vapor phase growth apparatus 300 according to the third embodiment is, for example, an epitaxial growth apparatus that epitaxially grows a single crystal SiC film on a single crystal SiC substrate. The vapor phase growth apparatus 300 according to the third embodiment is a horizontal vapor phase growth apparatus in which a process gas is supplied to the surface of the SiC substrate from a horizontal direction with respect to the surface of the SiC substrate.

The vapor phase growth apparatus 300 according to the third embodiment includes a reactor 10 and a gas introduction unit 12. The reactor 10 includes a susceptor 14 (holder), a rotating shaft 18, a rotation driving mechanism 20, a heater 23, and a gas discharge port 44. The gas introduction unit 12 includes a source gas region 56, a purge gas region 57, partition plate 66 and 67, a top plate 65, a source gas conduit 77, a purge gas conduit 78, a source gas introduction port 86, and a purge gas introduction port 87.

The susceptor 14 is an example of a holder. The partition plate 67 is an example of a second partition plate. The partition plate 66 is an example of a first partition plate.

The source gas region 56 and the source gas conduit 77 form a first source gas flow path. The purge gas region 57 and the purge gas conduit 78 form a purge gas flow path.

The susceptor 14 is provided in the reactor 10. A plurality of wafers W can be placed on the susceptor 14 at the same time.

The susceptor 14 is fixed to the rotating shaft 18. By rotating the rotating shaft 18 using the rotation driving mechanism 20, it is possible to rotate the susceptor 14. A plurality of wafers W placed on the susceptor 14 can also be made to rotate.

The heater 23 is provided below the susceptor 14. The heater 23 is, for example, a resistor heater. Alternatively, the heater 23 may be an induction heating type coil.

The gas discharge port 44 is provided on the side surface of the reactor 10. The gas discharge port 44 discharges a surplus reaction product after the source gas reacts on the surface of the wafer W and a surplus process gas from the side surface of the reactor 10 to the outside of the reactor 10.

The gas introduction unit 12 is provided above the reactor 10. The configuration of the gas introduction unit 12 is the same as that in the vapor phase growth apparatus 200 according to the second embodiment. However, the partition plate 67 may have a structure in which a hole corresponding to the purge gas conduit 78 and a plurality of other gas holes are provided, but may have a structure in which only a hole corresponding to the purge gas conduit 78 is provided.

When forming the SiC film 11 on the surfaces of a plurality of wafers W, the source gas Gx and the purge gas Gy supplied from the gas introduction unit 12 to the reactor 10 are supplied from the horizontal direction of the surfaces of the wafers W.

As described above, according to the vapor phase growth apparatus and the vapor phase growth method according to the third embodiment, the deposition of silicon-containing by-products in the gas flow path can be suppressed, as in the second embodiment. Therefore, according to the vapor phase growth apparatus and the vapor phase growth method according to the third embodiment, it is possible to improve the reproducibility of the film characteristics.

### (Fourth Embodiment)

A vapor phase growth apparatus according to a fourth embodiment is different from the vapor phase growth apparatus according to the first embodiment in that a gas introduction unit further includes a conductance adjustment mechanism attached to a source gas conduit. Hereinafter, the description of a part of the content overlapping the first embodiment may be omitted.

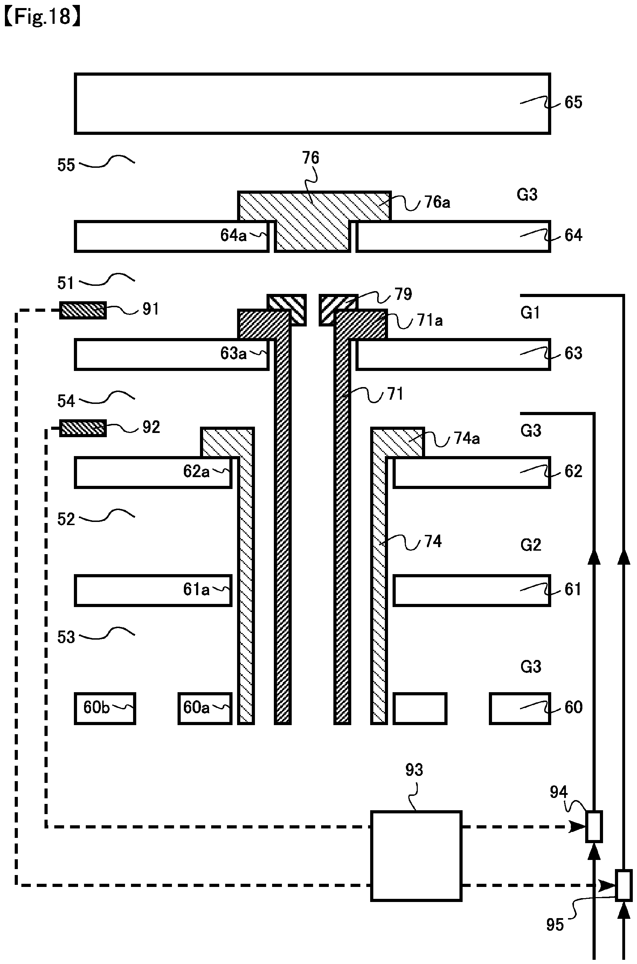

Fig. 18 is an enlarged schematic cross-sectional view of a part of a gas introduction unit of the vapor phase growth apparatus according to the fourth embodiment. Fig. 18 is a cross-sectional view including a source gas conduit 71 and a purge gas conduit 74. Fig. 18 is a diagram corresponding to Fig. 2 of the first embodiment. Fig. 18 also schematically shows a mass flow controller (MFC) and a control unit provided outside the reactor 10.

A conductance adjustment mechanism 79 is attached to the top of the source gas conduit 71. The conductance adjustment mechanism 79 has a function of making the combined conductance of the source gas conduit 71 and the conductance adjustment mechanism 79 smaller than the conductance of the source gas conduit 71. By attaching the conductance adjustment mechanism 79 to the source gas conduit 71, the supply amount of the source gas G1 supplied to the reactor 10 through the source gas conduit 71 is reduced.

The conductance adjustment mechanism 79 is, for example, an annular member having a predetermined inner diameter. A part of the conductance adjustment mechanism 79 is inserted into the source gas conduit 71, for example.

The conductance adjustment mechanism 79 has, for example, an annular flange at its upper end. The conductance adjustment mechanism 79 can be removed from the source gas conduit 71. The conductance adjustment mechanism 79 supports its own weight, for example, by placing the flange on the flange 71a of the source gas conduit 71.

In the vapor phase growth apparatus according to the fourth embodiment, for example, the source gas region 51 and the purge gas region 54 have pressure sensors 91 and 92, respectively. By the pressure sensors 91 and 92, the internal pressure of the source gas region 51 and the internal pressure of the purge gas region 54 can be independently measured.

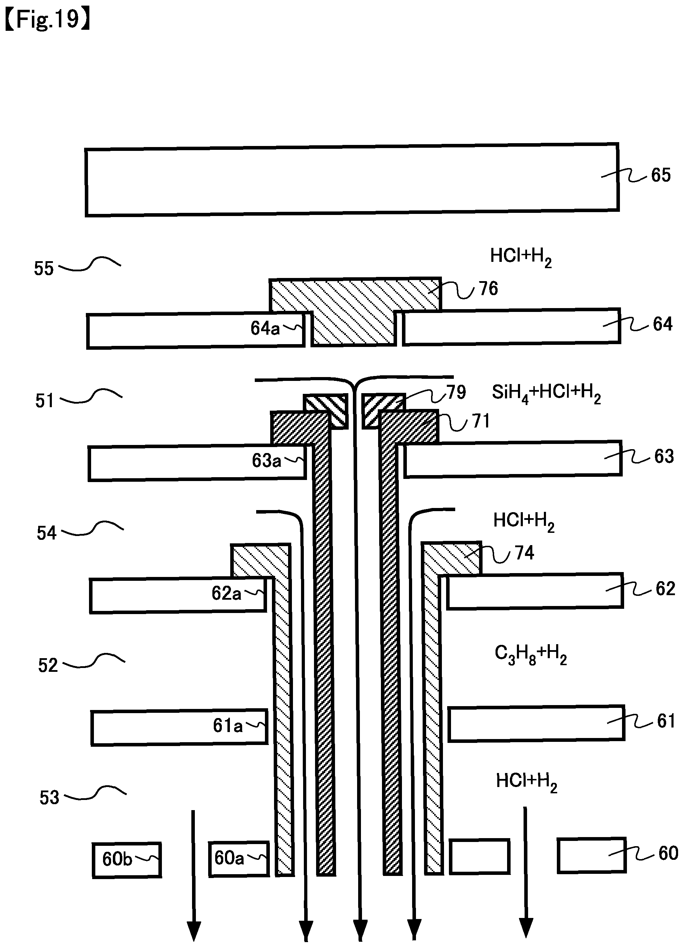

Fig. 19 is an explanatory diagram of the vapor phase growth method according to the fourth embodiment.

As shown in Fig. 19, a mixed gas of silane, hydrogen chloride, and hydrogen gas that is supplied as the source gas G1 is supplied from the source gas region 51 to the reactor 10 through the source gas conduit 71 to which the conductance adjustment mechanism 79 is attached. The source gas region 51 and the source gas conduit 71 form a source gas flow path for the source gas G1. The source gas flow path for the source gas G1 is an example of a first source gas flow path.

In addition, as shown in Fig. 19, a mixed gas of hydrogen chloride and hydrogen gas, which is the purge gas G3, is supplied from the purge gas region 54 to the reactor 10 through the purge gas conduit 74. The purge gas G3 is supplied to the reactor 10 through the gap between the purge gas conduit 74 and the source gas conduit 71. The purge gas region 54 and the purge gas conduit 74 form a purge gas flow path for the purge gas G3.

In addition, as shown in Fig. 19, a mixed gas of hydrogen chloride and hydrogen gas, which is the purge gas G3, is supplied from the purge gas region 53 to the reactor 10 through the holes 60b of the rectifying plate 60.

In the vapor phase growth method according to the fourth embodiment, for example, a mass flow controller 94 adjusts the supply amount of hydrogen gas in the purge gas G3 supplied to the purge gas region 54 by the control unit 93. By adjusting the supply amount of hydrogen gas in the purge gas G3 supplied to the purge gas region 54, the internal pressure of the purge gas region 54 can be adjusted. By adjusting the supply amount of hydrogen gas in the purge gas G3 supplied to the purge gas region 54, the difference between the internal pressure of the purge gas region 54 and the internal pressure of the source gas region 51 can be adjusted. For example, the internal pressure of the purge gas region 54 can be made equal to or higher than the internal pressure of the source gas region 51 by increasing the supply amount of hydrogen gas in the purge gas G3 supplied to the purge gas region 54. In addition, the hydrogen gas flow rate of the source gas G1 may be adjusted by a mass flow controller 95.

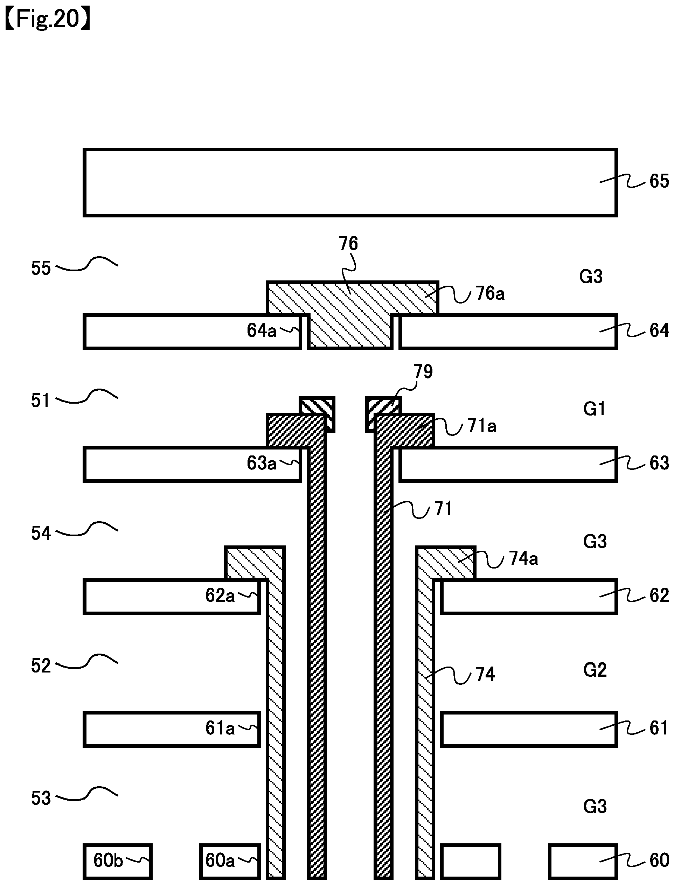

Fig. 20 is an enlarged schematic cross-sectional view of a part of a gas introduction unit of the vapor phase growth apparatus according to the fourth embodiment. Fig. 20 is a diagram corresponding to Fig. 18.

In the vapor phase growth method according to the fourth embodiment, for example, the inner diameter of the conductance adjustment mechanism 79 is adjusted. By adjusting the inner diameter of the conductance adjustment mechanism 79, the combined conductance of the source gas conduit 71 and the conductance adjustment mechanism 79 can be adjusted. By adjusting the combined conductance of the source gas conduit 71 and the conductance adjustment mechanism 79, the internal pressure of the source gas region 51 can be adjusted. By adjusting the combined conductance of the source gas conduit 71 and the conductance adjustment mechanism 79, the difference between the internal pressure of the purge gas region 54 and the internal pressure of the source gas region 51 can be adjusted.

The inner diameter of the conductance adjustment mechanism 79 shown in Fig. 20 is larger than the inner diameter of the conductance adjustment mechanism 79 shown in Fig. 18. By increasing the inner diameter of the conductance adjustment mechanism 79, the combined conductance of the source gas conduit 71 and the conductance adjustment mechanism 79 can be increased. By increasing the combined conductance of the source gas conduit 71 and the conductance adjustment mechanism 79, the internal pressure of the source gas region 51 can be lowered. By increasing the combined conductance of the source gas conduit 71 and the conductance adjustment mechanism 79, the internal pressure of the purge gas region 54 can be made equal to or higher than the internal pressure of the source gas region 51.

In the vapor phase growth method according to the fourth embodiment, the difference between the internal pressure of the purge gas region 54 and the internal pressure of the source gas region 51 is adjusted, for example, based on the internal pressure of the source gas region 51 and the internal pressure of the purge gas region 54 that are independently measured.

In the vapor phase growth method according to the fourth embodiment, the difference between the internal pressure of the purge gas region 54 and the internal pressure of the source gas region 51 is adjusted, for example, based on the amount of silicon-containing particles supplied to the surface of the wafer W. When performing such adjustment, the supply amount of hydrogen gas in the purge gas G3 supplied to the purge gas region 54, the supply amount of hydrogen gas in the source gas G1 supplied to the source gas region 51, the inner diameter of the conductance adjustment mechanism 79, and the like may be adjusted such that the density of silicon-containing particles is reduced. Therefore, the source gas region 51 and the purge gas region 54 may not include the pressure sensors 91 and 92, respectively. The density of silicon-containing particles supplied to the surface of the wafer W can be evaluated, for example, by introducing the wafer W into the vapor phase growth apparatus 100, then increasing the temperature of the wafer W to the vicinity of the growth temperature of the SiC film, and performing measurement using the Raman spectroscopy, an optical microscope, and the like on the wafer W unloaded from the vapor phase growth apparatus 100 without growing the SiC film. The density of silicon-containing particles supplied to the surface of the wafer W is preferably 100/cm² or less, more preferably 10/cm² or less, and even more preferably 1.0/cm² or less.

If the conductance adjustment mechanism 79 is attached to the source gas conduit 71, a single crystal SiC film formed on the surface of the wafer W may have small pits or bumps.

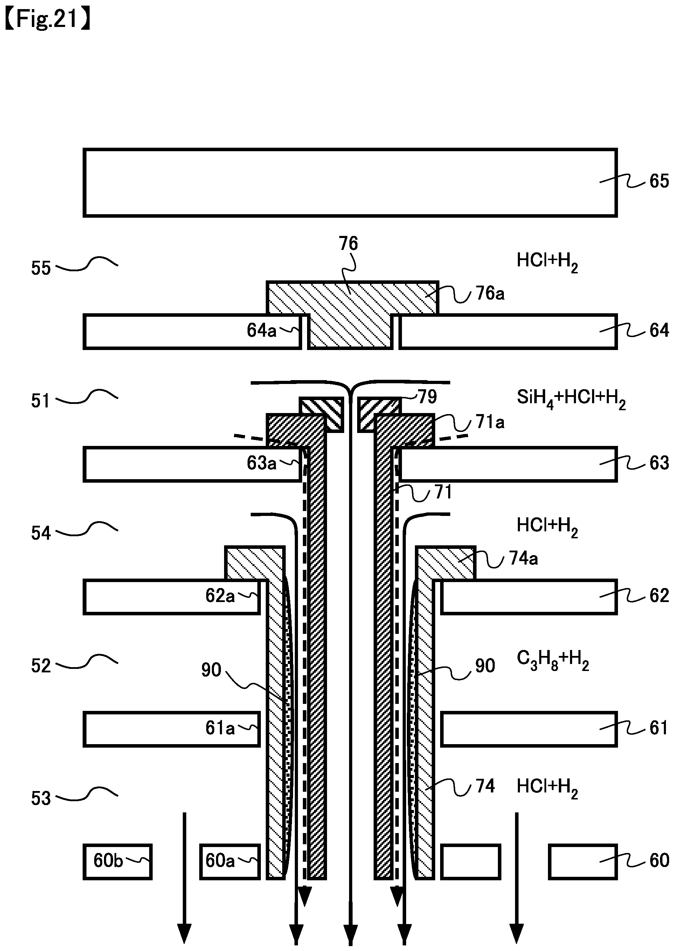

Fig. 21 is an explanatory diagram of the function and effect of the vapor phase growth apparatus and the vapor phase growth method according to the fourth embodiment. Fig. 21 is a diagram corresponding to Fig. 18.

As shown in Fig. 21, the contact surface between the flange 71a and the partition plate 63 and the region between the outer wall of the source gas conduit 71 and the partition plate 63 may function as a gas leak path. That is, as indicated by the dotted arrow in Fig. 21, the source gas G1 may leak from the source gas region 51 to the purge gas region 54 through the region between the outer wall of the source gas conduit 71 and the partition plate 63. Since the source gas G1 leaks into the purge gas region 54, the source gas G1 is mixed in the purge gas region 54.

Since the mixed gas of silane, hydrogen chloride, and hydrogen gas, which is the source gas G1, is mixed in the purge gas region 54, silicon-containing by-products 90 are deposited between the source gas conduit 71 and the purge gas conduit 74 as shown in Fig. 21.

As described in the first embodiment, by making chlorine contained in the purge gas G3, even if a gas containing silicon is mixed in the purge gas region 54 due to leakage of the source gas G1, silicon by-products are etched by chlorine. Therefore, the deposition of the silicon-containing by-products 90 in the gas flow path to the reactor 10 is suppressed.

However, when the conductance adjustment mechanism 79 is attached to the source gas conduit 71, the internal pressure of the source gas region 51 increases, and the difference between the internal pressure of the purge gas region 54 and the internal pressure of the source gas region 51 increases. As a result, the amount of the source gas G1 leaking from the source gas region 51 to the purge gas region 54 increases. For this reason, the effect of suppressing the deposition of the silicon-containing by-products 90 due to the chlorine in the purge gas G3 may be insufficient, and accordingly a large amount of by-products 90 may be formed.

It is thought that some of the large amount of by-products 90 deposited in the gas flow path are discharged into the vapor phase to become silicon-containing particles to be supplied to the surface of the wafer W. In addition, it is also thought that silicon-containing particles may be formed by vapor phase reaction between the source gas conduit 71 and the purge gas conduit 74 due to an increase in the concentration of the source gas G1 in the purge gas G3.

Adhesion of silicon-containing particles supplied to the surface of the wafer W before the growth of the SiC film may cause small pits or bumps in the single crystal SiC film.

In the vapor phase growth apparatus and the vapor phase growth method according to the fourth embodiment, the amount of the source gas G1 leaking from the source gas region 51 to the purge gas region 54 is suppressed by adjusting the difference between the internal pressure of the purge gas region 54 and the internal pressure of the source gas region 51. By making the internal pressure of the purge gas region 54 equal to or higher than the internal pressure of the source gas region 51, the amount of the source gas G1 leaking from the source gas region 51 to the purge gas region 54 is suppressed. Therefore, the deposition of the silicon-containing by-products 90 in the gas flow path to the reactor 10 is suppressed. In addition, vapor phase reaction occurring between the source gas conduit 71 and the purge gas conduit 74 are suppressed. Therefore, since the amount of silicon-containing particles supplied to the surface of the wafer W is reduced, the formation of small pits or bumps in the single crystal SiC film is suppressed.

As described above, according to the vapor phase growth apparatus and the vapor phase growth method according to the fourth embodiment, the deposition of silicon-containing by-products in the gas flow path can be suppressed, as in the first embodiment. Therefore, according to the vapor phase growth apparatus and the vapor phase growth method according to the fourth embodiment, it is possible to improve the reproducibility of the film characteristics. In addition, the formation of small pits or bumps in the SiC film is suppressed.

The embodiments of the invention have been described above with reference to specific examples. The above-described embodiments are merely given as examples, and do not limit the invention. In addition, the components of the respective embodiments may be combined as appropriate.

In the embodiments, the case of forming a single crystal SiC film has been described as an example. However, the invention can also be applied to the formation of a polycrystalline or amorphous SiC film.

In addition, in the embodiments, the wafer of single crystal SiC has been described as an example of the substrate. However, the substrate is not limited to the wafer of single crystal SiC.

In addition, in the embodiments, nitrogen has been described as an example of the n-type impurity. However, for example, phosphorus (P) can be applied as the n-type impurity. In addition, p-type impurities can also be applied as impurities.

In addition, in the embodiments, the case where the conduit has a cylindrical shape has been described as an example. However, the shape of the conduit is not limited to the cylindrical shape and may be any other shape. In addition, in the embodiments, the case where the opening cross section of the conduit is circular has been described as an example. However, the opening cross section of the conduit is not limited to the circular shape, and may have other shapes such as an ellipse, a square, and a rectangle.

In the embodiments, the case of improving the reproducibility of the characteristics of the film formed under the same process conditions between different vapor phase growth apparatuses having the same specifications has been described as an example. However, for example, when the characteristics of the film change with time in the same vapor phase growth apparatus, the invention can also be used to improve the reproducibility of the characteristics of the film. In addition, for example, when it is desired to improve the uniformity of the film characteristics with the same vapor phase growth apparatus, the invention can also be used.

In the embodiments, the case where a leak path is formed by providing a removable gas pipe has been described as an example. However, the invention can also be applied to other vapor phase growth apparatuses having a leak path in the gas introduction unit.

In the embodiments, the description of parts that are not directly required for the description of the invention, such as the apparatus configuration or the manufacturing method, is omitted. However, the required apparatus configuration, manufacturing method, and the like can be appropriately selected and used. In addition, all vapor phase growth apparatuses that include the elements of the invention and that can be appropriately redesigned by those skilled in the art are included in the scope of the invention. The scope of invention is defined by the scope of claims and the scope of their equivalents.

### EXPLANATIONS OF LETTERS OR NUMERALS

- 10: REACTOR
- 11: SiC FILM (SILICON CARBIDE FILM)
- 12: GAS INTRODUCTION UNIT
- 14: SUSCEPTOR (HOLDER)
- 51, 56: SOURCE GAS REGION
- 53, 54, 55: PURGE GAS REGION
- 60: RECTIFYING PLATE (PARTITION PLATE)
- 57: PURGE GAS REGION
- 60a, 60b, 62a, 63a, 64a: HOLE
- 62, 63, 64, 67: PARTITION PLATE
- 71, 77: SOURCE GAS CONDUIT
- 74, 75, 78: PURGE GAS CONDUIT
- 79: CONDUCTANCE ADJUSTMENT MECHANISM
- 100: VAPOR PHASE GROWTH APPARATUS
- 200: VAPOR PHASE GROWTH APPARATUS
- 300: VAPOR PHASE GROWTH APPARATUS
- G1: SOURCE GAS
- G2: SOURCE GAS
- G3: PURGE GAS
- Gx: SOURCE GAS
- Gy: PURGE GAS
- W: WAFER (SUBSTRATE)

## Claims

1. A vapor phase growth apparatus, comprising:
a reactor;
a holder provided in the reactor, the holder configured to place a substrate thereon;
a first source gas flow path configured to supply a first source gas containing silicon and chlorine into the reactor; and
a purge gas flow path configured to supply a purge gas containing silicon and chlorine into the reactor, an atomic concentration of silicon in the purge gas being lower than that in the first source gas.

2. The vapor phase growth apparatus according to claim 1,
wherein an atomic concentration of chlorine in the purge gas is lower than that in the first source gas.

3. The vapor phase growth apparatus according to claim 1, further comprising:
a gas leak path provided between the first source gas flow path and the purge gas flow path.

4. The vapor phase growth apparatus according to claim 1, further comprising:
a second source gas flow path configured to supply a second source gas containing carbon into the reactor.

5. The vapor phase growth apparatus according to claim 1,
wherein the purge gas contains a hydrogen gas.

6. A vapor phase growth apparatus, comprising:
a reactor;
a holder provided in the reactor, the holder configured to place a substrate thereon; and
a gas introduction unit provided above the reactor,
wherein the gas introduction unit includes:
a source gas region, a source gas containing silicon and chlorine being introduced into the source gas region;
a purge gas region provided between the source gas region and the reactor, a purge gas containing chlorine being introduced into the purge gas region;
a first partition plate provided between the source gas region and the purge gas region;
a second partition plate provided between the purge gas region and the reactor;
a source gas conduit passing through the first partition plate and the second partition plate and supplying the source gas to the reactor; and
a purge gas conduit passing through the second partition plate and supplying the purge gas containing silicon with an atomic concentration lower than an atomic concentration of silicon in the source gas to the reactor through a gap between the source gas conduit and the purge gas conduit, the source gas conduit being inserted into the purge gas conduit, and
the gas introduction unit has a gap between the source gas conduit and the first partition plate.

7. The vapor phase growth apparatus according to claim 6,
wherein the gas introduction unit further includes a conductance adjustment mechanism attached to the source gas conduit.

8. The vapor phase growth apparatus according to claim 6,
wherein an atomic concentration of chlorine in the purge gas is lower than that in the source gas.

9. The vapor phase growth apparatus according to claim 6,
wherein the purge gas contains a hydrogen gas.

10. A vapor phase growth method using a vapor phase growth apparatus including a reactor, a holder provided in the reactor configured to place a substrate thereon, a source gas flow path configured to supply a source gas into the reactor, and a purge gas flow path configured to supply a purge gas into the reactor, the method comprising:
supplying the source gas containing silicon and chlorine to the reactor through the source gas flow path;
supplying a purge gas containing silicon and chlorine to the reactor through the purge gas flow path, an atomic concentration of silicon in the purge gas being lower than that in the source gas; and
forming a silicon carbide film on a surface of the substrate.

11. The vapor phase growth method according to claim 10,
wherein an atomic concentration of chlorine in the purge gas is lower than that in the source gas.

12. The vapor phase growth method according to claim 10, further comprising:
a gas leak path provided between the source gas flow path and the purge gas flow path.

13. The vapor phase growth method according to claim 10,
wherein the purge gas contains a hydrogen gas.

14. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
an internal pressure of the purge gas region is set to be equal to or higher than an internal pressure of the source gas region.

15. The vapor phase growth method according to claim 14,
wherein the source gas contains a hydrogen gas, the purge gas contains a hydrogen gas, and the internal pressure of the purge gas region or the internal pressure of the source gas region is adjusted by adjusting a supply amount of a hydrogen gas introduced into the source gas region or a hydrogen gas introduced into the purge gas region.

16. The vapor phase growth method according to claim 14,
wherein the internal pressure of the purge gas region or the internal pressure of the source gas region is adjusted by adjusting a conductance of the source gas conduit or the purge gas conduit.

17. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 100/cm² or less.

18. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 10/cm² or less.

19. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 1.0/cm² or less.

## Amended claims

### Amended claims under Art. 19.1 PCT

1. (Amended) A vapor phase growth apparatus, comprising:
a reactor;
a holder provided in the reactor, the holder configured to place a substrate there on;
a first source gas flow path configured to supply a first source gas containing silicon and chlorine into the reactor;
a purge gas flow path configured to supply a purge gas containing silicon and chlorine into the reactor, an atomic concentration of silicon in the purge gas being lower than an atomic concentration of silicon in the first source gas; and
a gas leak path provided between the first source gas flow path and the purge gas flow path.

2. The vapor phase growth apparatus according to claim 1,
wherein an atomic concentration of chlorine in the purge gas is lower than an atomic concentration of chlorine in the first source gas.

3. (Deleted)

4. The vapor phase growth apparatus according to claim 1, further comprising:
a second source gas flow path configured to supply a second source gas containing carbon into the reactor.

5. The vapor phase growth apparatus according to claim 1,
wherein the purge gas contains a hydrogen gas.

6. A vapor phase growth apparatus, comprising:
a reactor;
a holder provided in the reactor, the holder configured to place a substrate thereon; and
a gas introduction unit provided above the reactor,
wherein the gas introduction unit includes:
a source gas region, a source gas containing silicon and chlorine being introduced into the source gas region;
a purge gas region provided between the source gas region and the reactor, a purge gas containing chlorine being introduced into the purge gas region;
a first partition plate provided between the source gas region and the purge gas region;
a second partition plate provided between the purge gas region and the reactor;
a source gas conduit passing through the first partition plate and the second partition plate and supplying the source gas to the reactor; and
a purge gas conduit passing through the second partition plate and supplying the purge gas containing silicon with an atomic concentration lower than an atomic concentration of silicon in the source gas to the reactor through a gap between the source gas conduit and the purge gas conduit, the source gas conduit being inserted into the purge gas conduit, and
the gas introduction unit has a gap between the source gas conduit and the first partition plate.

7. The vapor phase growth apparatus according to claim 6,
wherein the gas introduction unit further includes a conductance adjustment mechanism attached to the source gas conduit.

8. The vapor phase growth apparatus according to claim 6,
wherein an atomic concentration of chlorine in the purge gas is lower than an atomic concentration of chlorine in the source gas.

9. The vapor phase growth apparatus according to claim 6,
wherein the purge gas contains a hydrogen gas.

10. (Amended) A vapor phase growth method using a vapor phase growth apparatus including a reactor, a holder provided in the reactor configured to place a substrate thereon, a source gas flow path configured to supply a source gas into the reactor, a purge gas flow path configured to supply a purge gas into the reactor, and a gas leak path provided between the first source gas flow path and the purge gas flow path, the method comprising:
supplying the source gas containing silicon and chlorine to the reactor through the source gas flow path;
supplying a purge gas containing silicon and chlorine to the reactor through the purge gas flow path, an atomic concentration of silicon in the purge gas being lower than an atomic concentration of silicon in the source gas; and
forming a silicon carbide film on a surface of the substrate.

11. The vapor phase growth method according to claim 10,
wherein an atomic concentration of chlorine in the purge gas is lower than an atomic concentration of chlorine in the source gas.

12. (Deleted)

13. The vapor phase growth method according to claim 10,
wherein the purge gas contains a hydrogen gas.

14. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
an internal pressure of the purge gas region is set to be equal to or higher than an internal pressure of the source gas region.

15. The vapor phase growth method according to claim 14,
wherein the source gas contains a hydrogen gas, the purge gas contains a hydrogen gas, and the internal pressure of the purge gas region or the internal pressure of the source gas region is adjusted by adjusting a supply amount of a hydrogen gas introduced into the source gas region or a hydrogen gas introduced into the purge gas region.

16. The vapor phase growth method according to claim 14,
wherein the internal pressure of the purge gas region or the internal pressure of the source gas region is adjusted by adjusting a conductance of the source gas conduit or the purge gas conduit.

17. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 100/cm² or less.

18. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 10/cm² or less.

19. The vapor phase growth method according to claim 10,
wherein the source gas flow path includes a source gas region and a source gas conduit configured to supply the source gas from the source gas region to the reactor, the source gas being introduced into the source gas region,
the purge gas flow path includes a purge gas region and a purge gas conduit configured to supply the purge gas from the purge gas region to the reactor, the purge gas being introduced into the purge gas region, and
the source gas contains a hydrogen gas, the purge gas contains a hydrogen gas, and a supply amount of a hydrogen gas introduced into the source gas region or a hydrogen gas introduced into the purge gas region is adjusted such that a density of silicon-containing particles supplied to the surface of the substrate is 1.0/cm² or less.
